(19) Europäisches Patentamt
European Patent Office
Office européen des brevets

(11) **EP 4 597 354 A1**

(12) **EUROPEAN PATENT APPLICATION**
published in accordance with Art. 153(4) EPC

(43) Date of publication:
**06.08.2025 Bulletin 2025/32**

(21) Application number: **23927113.3**

(22) Date of filing: **31.10.2023**

(51) International Patent Classification (IPC):
**G06F 30/398** (2020.01)

(52) Cooperative Patent Classification (CPC):
**G06N 3/08; G03F 1/36; G03F 1/68; G03F 1/70; G06F 30/398; G06N 3/045; G06N 3/0464; G06N 3/048**

(86) International application number:
**PCT/CN2023/128438**

(87) International publication number:
**WO 2024/187772 (19.09.2024 Gazette 2024/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **10.03.2023 CN 202310284682**

(71) Applicant: **Tencent Technology (Shenzhen) Company Limited**
**Shenzhen, Guangdong 518057 (CN)**

(72) Inventors:
• **MA, Xingyu**
**Shenzhen, Guangdong 518057 (CN)**
• **HAO, Shaogang**
**Shenzhen, Guangdong 518057 (CN)**
• **ZHANG, Shengyu**
**Shenzhen, Guangdong 518057 (CN)**

(74) Representative: **Gunzelmann, Rainer**
**Wuesthoff & Wuesthoff**
**Patentanwälte und Rechtsanwalt PartG mbB**
**Schweigerstraße 2**
**81541 München (DE)**

(54) **MASK LAYOUT DETERMINATION MODEL TRAINING METHOD AND DEVICE, AND MASK LAYOUT DETERMINATION METHOD AND DEVICE**

(57) A mask layout determination model training method and device, and a mask layout determination method and device, relating to the technical field of integrated circuits. The mask layout determination model training method comprises: acquiring a labeled mask layout and a sample chip layout (201); determining a predicted mask layout of the sample chip layout by means of a neural network model (202); determining a first wafer layout of the predicted mask layout by means of a first wafer layout determination model (203); and training the neural network model by means of the labeled mask layout, the predicted mask layout, the sample chip layout, and the first wafer layout to obtain a mask layout determination model (204). The use of the methods and devices improves the quality of a target mask layout, such that under the conditions of actual photolithography process parameters, a wafer layout that is highly similar to the target chip layout can be obtained on the basis of the target mask layout.

Obtain a labeled mask layout and a sample chip layout 201

Determine a predicted mask layout of the sample chip layout through a neural network model 202

Determine a first wafer layout of the predicted mask layout through a first wafer layout determining model 203

Train the neural network model through the labeled mask layout, the predicted mask layout, the sample chip layout, and the first wafer layout, to obtain a mask layout determining model 204

FIG. 2

**Description**

RELATED APPLICATION

This application claims priority to Chinese Patent Application No. 202310284682.2, entitled "MASK LAYOUT DETERMINING MODEL TRAINING METHOD AND APPARATUS, AND MASK LAYOUT DETERMINING METHOD AND APPARATUS" filed on March 10, 2023.

FIELD OF THE TECHNOLOGY

Embodiments of the present disclosure relate to the field of integrated circuit (IC) technologies, and in particular, to a method and device for training a model for determining a mask layout, and a method and device for determining a mask layout.

BACKGROUND OF THE DISCLOSURE

In an IC technology, an IC layout needs to be first designed. Then, a lithography machine is invoked to expose the IC layout on a photoresist to obtain a mask layout. Subsequently, the lithography machine is invoked again to expose the mask layout on a wafer to obtain a wafer layout.

The IC layout may alternatively be referred to as a chip layout. As a design size is continuously reduced, a design size of the chip layout is already approximate to or smaller than a light source wavelength used in a lithography process. Consequently, an interference effect and a scattering effect are clearer, so that an actually formed wafer layout is seriously distorted compared with the mask layout, and the wafer layout is different from the chip layout. Based on this, how to obtain the mask layout is a problem to be solved urgently.

SUMMARY

The present disclosure provides a method and device for training a model for determining a mask layout, and a method and device for determining a mask layout. The quality of a mask layout can be improved, so that a wafer layout determined based on the mask layout is highly similar to a chip layout. The technical solution includes the following content.

A first aspect provides a method for determining a model for determining a mask layout is provided. The method is performed by an electronic device, and includes:

obtaining a labeled mask layout and a sample chip layout, where the labeled mask layout is a mask layout of the sample chip layout determined under conditions of a first lithography process parameter;

determining a predicted mask layout of the sample chip layout through a neural network model, where the predicted mask layout is a mask layout of the sample chip layout obtained by prediction;

determining a first wafer layout of the predicted mask layout through a first wafer layout determining model, where the first wafer layout determining model includes a second lithography process parameter, and the first wafer layout is a wafer layout of the predicted mask layout obtained by prediction; and

training the neural network model through the labeled mask layout, the predicted mask layout, the sample chip layout, and the first wafer layout, to obtain a model for determining a mask layout, where the model for determining a mask layout is configured for determining a target mask layout of a target chip layout.

According to a second aspect, a method for determining a mask layout is provided. The method is performed by an electronic device, and includes:

obtaining a target chip layout; and

determining a target mask layout of the target chip layout through a model for determining a mask layout, where the model for determining a mask layout is obtained by training through the method for training a model for determining a mask layout I according to any content in the first aspect, and the target mask layout is a mask layout of the target chip layout obtained by prediction.

According to a third aspect, a device for training a model for determining a mask layout is provided. The device includes:

an obtaining module, configured to obtain a labeled mask layout and a sample chip layout, where the labeled mask layout is a mask layout of the sample chip layout determined under conditions of a first lithography process parameter;

a determining module, configured to determine a predicted mask layout of the sample chip layout through a neural network model, where the predicted mask layout is a mask layout of the sample chip layout obtained by prediction;

the determining module, further configured to determine a first wafer layout of the predicted mask layout through a first wafer layout determining model, where the first wafer layout determining model includes a second lithography process parameter, and the first wafer layout is a wafer layout of the predicted mask layout obtained by prediction; and

a training module, configured to train the neural network model through the labeled mask layout, the predicted mask layout, the sample chip layout, and the first wafer layout, to obtain a model for determining a mask layout, where the model for determining a mask layout is configured for determining a target mask layout of a target chip layout.

According to a fourth aspect, a device for determining a mask layout is provided. The device includes:

an obtaining module, configured to obtain a target chip layout; and

a determining module, configured to determine a target mask layout of the target chip layout through a model for determining a mask layout, where the mask layout determining model is obtained by training through the method for training a model for determining a mask layout according to any content in the first aspect, and the target mask layout is a mask layout of the target chip layout obtained by prediction.

According to a fifth aspect, an electronic device is provided. The electronic device includes a processor and a memory. The memory has at least one computer program stored therein. The at least one computer program is loaded and executed by the processor, to cause the electronic device to implement the method for training a model for determining a mask layout according to any content in the first aspect or the method for determining a mask layout according to any content in the second aspect.

According to a sixth aspect, a non-volatile computer-readable storage medium is further provided. The non-volatile computer-readable storage medium has at least one computer program stored therein. The at least one computer program is loaded and executed by a processor, to cause an electronic device to implement the method for training a model for determining a mask layout l according to any content in the first aspect or the method for determining a mask layout according to any content in the second aspect.

According to a seventh aspect, a computer program or a computer program product is further provided. The computer program or the computer program product has at least one computer program stored therein. The at least one computer program is loaded and executed by a processor, to cause an electronic device to implement the method for training a model for determining a mask layout according to any content in the first aspect or the method for determining a mask layout according to any content in the second aspect.

According to the technical solution provided in the present disclosure, a predicted mask layout of a sample chip layout is determined through a neural network model, and a first wafer layout in which a second lithography process parameter is considered is determined based on the predicted mask layout. The neural network model is trained through a labeled mask layout, the predicted mask layout, the sample chip layout, and the first wafer layout, to obtain a model for determining a mask layout, so that a target mask layout determined through the model for determining a mask layout better conforms to the second lithography process parameter, and a wafer layout highly similar to a target chip layout can be obtained under the conditions of the second lithography process parameter, thereby improving the quality of the target mask layout.

BRIEF DESCRIPTION OF THE DRAWINGS

FIG. 1 is a schematic diagram of an implementation environment for a method for training a model for determining a mask layout or a method for determining a mask layout according to an embodiment of the present disclosure.

FIG. 2 is a flowchart of a method for training a model for determining a mask layout according to an embodiment of the present disclosure.

FIG. 3 is a schematic diagram of an edge modification information according to an embodiment of the present disclosure.

FIG. 4 is a flowchart of determining a labeled mask layout according to an embodiment of the present disclosure.

FIG. 5 is a flowchart of a method for determining a mask layout according to an embodiment of the present disclosure.

FIG. 6 is a schematic diagram of pre-training an initial network model according to an embodiment of the present disclosure.

FIG. 7 is a schematic diagram of optimally training a neural network model according to an embodiment of the present disclosure.

FIG. 8 is a schematic diagram of a mask process window according to an embodiment of the present disclosure.

FIG. 9 is a structural diagram of a device for training a model for determining a mask layout according to an embodiment of the present disclosure.

FIG. 10 is a structural diagram of a device for determining a mask layout according to an embodiment of the present disclosure.

FIG. 11 is a schematic structural diagram of a terminal device according to an embodiment of the present disclosure.

FIG. 12 is a schematic structural diagram of a server according to an embodiment of the present disclosure.

DESCRIPTION OF EMBODIMENTS

To make the objects, technical solutions, and advantages of the present disclosure clearer, the following further describes implementations of the present disclosure in detail with reference to the accompanying drawings.

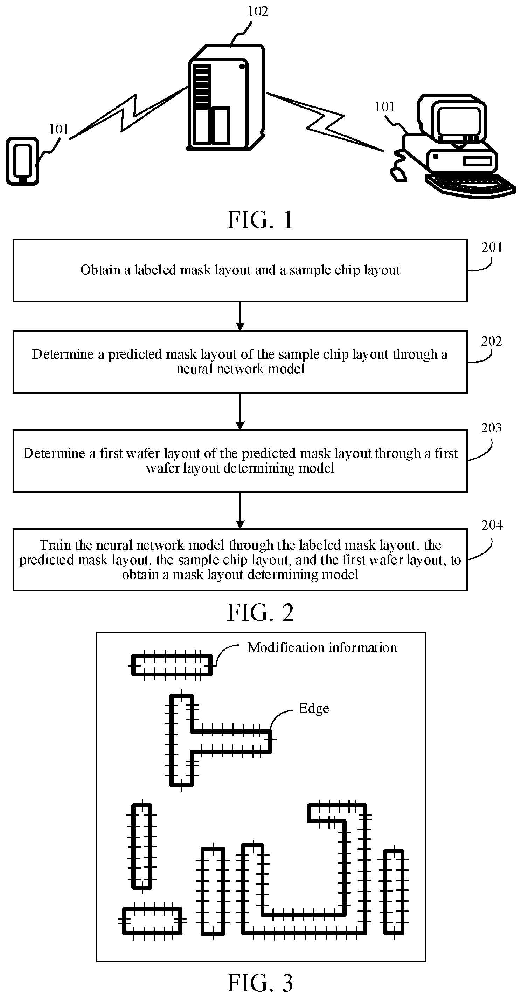

FIG. 1 is a schematic diagram of an implementation environment for a method for training a model for determining a mask layout or a method for determining a mask layout according to an embodiment of the present disclosure. As shown in FIG. 1, the implementation environment includes a terminal device 101 and a server 102. The method for training a model for determining a mask layout or the method for determining a mask layout in this embodiment of the present disclosure may be performed by the terminal device 101, or may be performed by the server 102, or may be performed jointly by the terminal device 101 and the server 102. A device for performing the method for training a model for determining a mask layout may be the same as or different from a device for performing the method for determining a mask layout.

The terminal device 101 may be a smartphone, a desktop computer, a tablet computer, a laptop portable computer, or the like. The server 102 may be one server, a server cluster formed by multiple servers, or any one of a cloud computing center or a virtualization center. This is not limited in this embodiment of the present disclosure. The server 102 may perform communication connection with the terminal device 101 through a wired network or a wireless network. The server 102 may have functions of data processing, data storage, data transmission and reception, and the like. This is not limited in this embodiment of the present disclosure. The quantity of terminal devices 101 and the quantity of servers 102 are not limited, and there may be one or more terminal devices and one or more servers.

Exemplary embodiments of the present disclosure may be implemented based on an artificial intelligence (AI) technology.

With continuous development of a computer technology, an IC technology also develops. In the field of IC technologies, an IC layout usually needs to be designed. A mask layout is obtained based on the IC layout. A wafer layout is obtained by exposing the mask layout on a wafer.

The IC layout may alternatively be referred to as a chip layout. As a design size is continuously reduced, a design size of the chip layout is already approximate to or smaller than a light source wavelength used in a lithography process. Consequently, an interference effect and a scattering effect are clearer, so that an actually formed wafer layout is seriously distorted compared with the mask layout, and the wafer layout is different from the chip layout. Based on this, how to improve the quality of the mask layout is a problem to be solved urgently.

This embodiment of the present disclosure provides a method for training a model for determining a mask layout. The model for determining a mask layout may also be called as a mask layout determining model in the present disclosure. The method may be applied to the foregoing implementation environment. The quality of a mask layout can be improved, so that a wafer layout determined based on the mask layout is highly similar to a chip layout. A flowchart of a method for training a model for determining a mask layout according to an embodiment of the present disclosure shown in FIG. 2 is used as an example. For ease of description, the terminal device 101 or the server 102 that performs the method for training a model for determining a mask layout in this embodiment of the present disclosure is referred to as an electronic device. The method may be performed by the electronic device. As shown in FIG. 2, the method includes the following operations 201 to 204.

Operation 201: Obtain a labeled mask layout and a sample chip layout.

The labeled mask layout is a mask layout of the sample chip layout determined under conditions of a first lithography process parameter which is a reference lithography process parameter.

The sample chip layout may be any chip layout. The chip layout is a pattern obtained after layout and connection of multiple circuit devices based on an implementation of a logic circuit. In short, the logic circuit may be first designed. For example, each function that needs to be implemented by the logic circuit is analyzed based on a requirement, and each function is simulated and verified, to obtain the logic circuit. Next, information such as a circuit device type, a quantity of circuit devices, a size of the circuit devices, a relative position between the circuit devices, and a connection relationship between the circuit devices is determined based on the logic circuit, and the circuit devices are laid out and connected according to the information. The obtained pattern is the chip layout.

The mode of obtaining the sample chip layout is not limited in this embodiment of the present disclosure. For example, the electronic device may use any input chip layout as a sample chip layout, or the electronic device may capture a chip layout from a network to obtain the sample chip layout.

The sample chip layout is calculated to obtain a mask layout of the sample chip layout under conditions of the reference lithography process parameter. The mask layout is recorded as a labeled mask layout. The reference lithography process parameter refers to a set lithography process parameter. The lithography process parameter is a parameter of a lithography process. The lithography process is an operation in a semiconductor device manufacturing process, and mainly describes a geometric figure structure on a photoresist layer by exposure and development, and transfers, by an etching process, a pattern on a mask (i.e. the mask layout) to a substrate on which the photoresist layer is located. In the embodiment of the present disclosure including the embodiments both the claims and the specification (hereinafter referred to as "all embodiments of the present disclosure"), in the process of exposing the labeled mask layout on a wafer by a lithography machine, the lithography machine may preferably perform exposure based on a set lithography process parameter. The set lithography process parameter herein is a reference lithography process parameter. To be specific, the reference lithography process parameter is a set lithography process parameter according to which the labeled mask layout is exposed on the wafer by the lithography machine.

In an exemplary embodiment, the reference lithography process parameter is determined through a defocus process parameter distribution function and/or an exposure dose deviation process parameter distribution function. For example, a value of an independent variable for the reference lithography process parameter is substituted into the defocus process parameter distribution function, to obtain a first dependent variable value, and the first dependent variable value is used as the reference lithography process parameter. Alternatively, a value of an independent variable for the reference lithography process parameter is substituted into the exposure dose deviation process parameter distribution function, to obtain a second dependent variable value, and the second dependent variable value is used as the reference lithography process parameter. Alternatively, a value of an independent variable for the reference lithography process parameter is substituted into the defocus process parameter distribution function, to obtain a first dependent variable value, the value of the independent variable for the reference lithography process parameter is substituted into the exposure dose deviation process parameter distribution function, to obtain a second dependent variable value, and the first dependent variable value and the second dependent variable value are used as the reference lithography process parameter.

The defocus process parameter distribution function is configured for describing energy distribution of light on a workpiece in a case that a positional relationship between a focus and the workpiece is determined. In this embodiment of the present disclosure, the focus refers to a focus of the lithography machine, and the workpiece includes the wafer. The focus may be above the workpiece, may be inside the workpiece, or may be below the workpiece. The focus being above the workpiece is referred to as a positive defocus, and the focus being inside the workpiece or the focus being below the workpiece is referred to as a negative defocus. The defocus process parameter distribution function is shown in the following formula (1).

$$\xi(h_\mu) = \exp\{-\frac{(h_\mu)^2}{2(\sigma_h)^2}\} \quad \text{Formula (1)}$$

where $\xi(h_\mu)$ represents the defocus process parameter distribution function, exp represents an exponential function with a natural constant e as a base, and $h_\mu$ represents a distance between the wafer and a focal plane of the lithography machine. The focus of the lithography machine is located on the focal plane of the lithography machine. $\sigma_h$ represents distribution

function broadening. Values of $h_\mu$ and $\sigma_h$ are not limited in this embodiment of the present disclosure. For example, for the reference lithography process parameter, $h_\mu$ = 0 nanometer (nm), $\sigma_h$ = 80. For example, the values of $h_\mu$ and $\sigma_h$ for the reference lithography process parameter are substituted into formula (1), to obtain a value of $\xi(h_\mu)$. The value of $\xi(h_\mu)$ is the first dependent variable value.

The exposure dose deviation process parameter distribution function is configured for describing an energy distribution deviation of light in different areas of the workpiece. The exposure dose deviation process parameter distribution function is shown in the following formula (2).

$$\zeta(t_q) = \exp\{-\frac{(t_q)^2}{2(\sigma_q)^2}\} \quad \text{Formula (2)}$$

where $\zeta(t_q)$ represents the exposure dose deviation process parameter distribution function. exp represents the exponential function with the natural constant e as the base, $t_q$ represents an exposure dose deviation of the lithography machine, and $\sigma_q$ represents distribution function broadening. Values of $t_q$ and $\sigma_q$ are not limited in this embodiment of the present disclosure. For example, for the reference lithography process parameter, $t_q$ = 0, $\sigma_q$ = 0.1. For example, the values of $t_q$ and $\sigma_q$ for the reference lithography process parameter are substituted into formula (2), to obtain a value of $\zeta(t_q)$. The value of $\zeta(t_q)$ is the second dependent variable value.

In a possible implementation, "obtaining a labeled mask layout" in operation 201 includes operations A1 to A3 (not shown).

Operation A1: Generate an initial mask layout based on the sample chip layout.

In some embodiments, the sample chip layout is linearly modified, to obtain a layout recorded as the initial mask layout. For example, a calculation formula of the initial mask layout is: $\overline{M}_0 = w_1 Z_t + w_2$, where $\overline{M}_0$ represents the initial mask layout, $w_1$ and $w_2$ represent linear modification parameters, and Zt represents the sample chip layout. Values of the linear modification parameters are not limited in this embodiment of the present disclosure. For example, $w_1$ = 0.98, $w_2$ = 0.1. A difference between the initial mask layout calculated based on the two values and the sample chip layout is relatively small. Therefore, when a first gradient of a reference loss relative to the initial mask layout is subsequently determined, a value of the first gradient is relatively large, facilitating subsequent gradient descent processing. Therefore, when the initial mask layout is adjusted based on the first gradient, an adjustment effect can be improved.

Operation A2: Determine a second wafer layout of the initial mask layout through a second wafer layout determining model, where the second wafer layout determining model includes the reference lithography process parameter, and the second wafer layout is a wafer layout of the initial mask layout obtained by prediction under the conditions of the reference lithography process parameter.

In some embodiments, the initial mask layout is directly inputted to the second wafer layout determining model, and the second wafer layout is outputted through the second wafer layout determining model. In some embodiments, the initial mask layout is activated, to obtain a reference mask layout, the reference mask layout is then inputted to the second wafer layout determining model, and the second wafer layout determining model is outputted through the second wafer layout determining model.

In some embodiments, the initial mask layout is activated according to the following formula (3) to obtain the reference mask layout.

$$M_0 = \frac{1}{1+\exp(-\theta_M \times (\overline{M}_0 - M_{th}))} \quad \text{Formula (3)}$$

where $M_0$ represents the reference mask layout, exp represents the exponential function with the natural constant e as the base, $\theta_M$ and $M_{th}$ represent activation processing parameters, and $\overline{M}_0$ represents the initial mask layout. Values of the activation processing parameters are not limited in this embodiment of the present disclosure. For example, $\theta_M$ = 4, $M_{th}$ = 0.225.

Formula (3) is a sigmoid function, where the sigmoid function is an activation function. In this embodiment of the present disclosure, the initial mask layout is a binary mask layout (a mask layout including two parts that are transparent and non-transparent), and it is very difficult to perform non-continuous optimization on the binary mask layout. Therefore, by activating the initial mask layout into the reference mask layout through the activation function, the non-continuous optimization performed on the binary mask layout may be converted into continuous optimization performed on the reference mask layout, thereby reducing the difficulty of optimization. Furthermore, the initial mask layout is activated into the reference mask layout through the activation function, so that tiny complex structures (for example, an island structure, a hollow structure, an aliasing structure, and an extension structure) in the initial mask layout may be filtered out, thereby reducing structural complexity of the reference mask layout, and increasing manufacturability of the reference mask layout.

In this embodiment of the present disclosure, a model structure, a model size, and the like of the second wafer layout determining model are not limited. For example, the second wafer layout determining model is a Hopkins diffraction lithography physical model based on a coherent imaging system. The model includes multiple kernel functions and an activation function. The kernel functions are obtained by performing singular value decomposition on a cross-transmission coefficient of the lithography system. In some embodiments, the lithography system is a 193nm annular light source system. Functions of the kernel functions and the activation function are correspondingly described below. Details are not described herein again.

In an exemplary embodiment, operation A2 includes operations A21 to A22 (not shown).

Operation A21: Determine reference light intensity distribution information based on the initial mask layout through the second wafer layout determining model, where the reference light intensity distribution information is a light intensity distribution obtained after the initial mask layout is imaged on a wafer under the conditions of the reference lithography process parameter.

In this embodiment of the present disclosure, the second wafer layout determining model includes multiple kernel functions. The initial mask layout may be convolved with the kernel functions, to obtain the reference light intensity distribution information based on convolution processing results. Alternatively, the initial mask layout may be first activated, to obtain a reference mask layout, and the reference mask layout may be then convolved with the kernel functions, to obtain the reference light intensity distribution information based on convolution processing results. In some embodiments, the reference light intensity distribution information is shown in the following formula (4).

$$I(x, y; h_\mu) = \sum_{k=1}^{K} \omega_k(h_\mu) |M(x, y) \otimes h_k(x, y; h_\mu)|^2 \quad \text{Formula (4)}$$

where M(x, y) represents the reference mask layout, x and y are parameters of the reference mask layout. I(x, y; $h_\mu$) represents the reference light intensity distribution information, where $h_\mu$ represents the distance between the wafer and the focal plane of the lithography machine. K represents a quantity of kernel functions, where the kernel functions are obtained by performing singular value decomposition on the cross transfer coefficient of the lithography system. In an exemplary embodiment, the first 24 kernel functions are obtained by performing singular value decomposition on the cross transfer coefficient of the lithography system. To be specific, K=24. $\omega_k(h_\mu)$ represents a weight coefficient of a $k^{th}$ kernel function, and $h_k(x, y; h_\mu)$ represents the $k^{th}$ kernel function. $\Sigma$ represents a function sign of summation processing, $\otimes$ represents a function sign of convolution processing, and | | represents a function sign of absolute value processing.

Since the second wafer layout determining model includes the reference lithography process parameter, in formula (4), $h_\mu = 0$.

Operation A22: Determine the second wafer layout based on the reference light intensity distribution information through the second wafer layout determining model.

In this embodiment of the present disclosure, the second wafer layout determining model includes an activation function. The reference light intensity distribution information is activated through the activation function, to obtain the second wafer layout. In some embodiments, the activation function is a sigmoid function. The reference light intensity distribution information is activated through the sigmoid function according to the following formula (5), to obtain the second wafer layout.

$$Z(x, y; h_\mu, t_q) = sig(I; h_\mu, t_q) = \frac{1}{1 + \exp(-\theta_Z \times (I(x, y; h_\mu) - I_{th}/(1 + t_q)))} \quad \text{Formula (5)}$$

where Z(x, y; $h_\mu$, $t_q$) represents the second wafer layout, x and y are parameters of the reference mask layout, $h_\mu$ represents the distance between the wafer and the focal plane of the lithography machine, and $t_q$ represents the exposure dose deviation of the lithography machine. sig(I; $h_\mu$, $t_q$) represents the sigmoid function, where I represents the reference light intensity distribution information. exp represents the exponential function with the natural constant e as the base. $\theta_Z$ and $I_{th}$ represent the activation processing parameters. For example, $\theta_Z = 50$, $I_{th} = 0.225$. I(x, y; $h_\mu$) represents the reference light intensity distribution information.

Since the second wafer layout determining model includes the reference lithography process parameter, in formula (5), $h_\mu = 0$, $t_q = 0$.

Operation A3: Adjust the initial mask layout based on the sample chip layout and the second wafer layout, to obtain the labeled mask layout.

In this embodiment of the present disclosure, the initial mask layout is constantly adjusted through the sample chip layout and the second wafer layout, so that the mask layout is constantly optimized toward a direction in which the wafer layout can increasingly approach the sample chip layout, thereby achieving high accuracy of the labeled mask layout.

In an exemplary embodiment, operation A3 includes operations A31 to A34 (not shown).

Operation A31: Determine a first reference sub-loss based on first difference information between the sample chip layout and the second wafer layout.

In this embodiment of the present disclosure, the first difference information between the sample chip layout and the second wafer layout may be calculated. For example, the first difference information may be calculated based on a difference between a pixel value of a pixel in the sample chip layout and a pixel value of a corresponding pixel in the second wafer layout. For example, a mean square error between the pixel value of the pixel in the sample chip layout and the pixel value of the corresponding pixel in the second wafer layout is used as the first difference information.

For example, the sample chip layout includes at least one geometrical pattern. A sum of perimeters of the geometrical patterns is used as an edge length of the sample chip layout. The first reference sub-loss is determined based on the first difference information and the edge length of the sample chip layout. An error between the sample chip layout and the second wafer layout is described through the first reference sub-loss. In some embodiments, the first reference sub-loss is determined according to the following formula (6).

$$L_{Aerial} = \frac{1}{L} \sum_{x=1}^{N} \sum_{y=1}^{N} (Z(x, y; h_{\mu}, t_q) - Z_t(x, y))^{\gamma} \qquad \text{Formula (6)}$$

where $L_{Aerial}$ represents the first reference sub-loss. L represents the edge length of the sample chip layout. $Z(x, y; h_{\mu}, t_q)$ - $Z_t(x, y)$ represents the first difference information. $Z_t(x, y)$ represents the sample chip layout, where x and y represent the parameters of the sample chip layout. N represents a side length of the sample chip layout. To be specific, the sample chip layout is a square with a side length of N. $Z(x, y; h_{\mu}, t_q)$ represents the second wafer layout, $h_{\mu}$ represents the distance between the wafer and the focal plane of the lithography machine, and $t_q$ represents the exposure dose deviation of the lithography machine. $\gamma$ is an adjustable parameter. For example, $\gamma = 2$.

A dimension of the edge length of the sample chip layout is a length unit, and a dimension of the first reference sub-loss is also a length unit. Furthermore, the sample chip layout is a square with a side length of N. Therefore, a dimension of the sample chip layout is also a length unit. In other words, the dimension of the edge length of the sample chip layout, the dimension of the first reference sub-loss, and the dimension of the sample chip layout remain the same.

Operation A32: Determine a reference loss based on the first reference sub-loss.

In an exemplary embodiment, the first reference sub-loss is used as the reference loss. Alternatively, the first reference sub-loss is weighted, to obtain a weighting result used as the reference loss. Alternatively, operation A32 includes operations A321 to A322 (not shown). To be specific, the reference loss is determined based on the first reference sub-loss according to the following operations A321 to A322.

Operation A321: Obtain at least one of a second reference sub-loss, a third reference sub-loss, a fourth reference sub-loss, a fifth reference sub-loss, or a sixth reference sub-loss, where the second reference sub-loss is determined based on the initial mask layout, the third reference sub-loss is determined based on second difference information between the sample chip layout and the initial mask layout, the fourth reference sub-loss is determined based on the first difference information and edge modification information, the fifth reference sub-loss is determined based on the initial mask layout and the edge modification information, the sixth reference sub-loss is determined based on the second difference information and the edge modification information, and the edge modification information is information for modifying an edge of the sample chip layout.

For example, the second reference sub-loss is directly determined based on the initial mask layout. For example, the initial mask layout is first activated, to obtain a reference mask layout, and the second reference sub-loss is then determined based on the reference mask layout. In an exemplary embodiment, a pixel value of the reference mask layout is between 0 and 1. To be specific, the reference mask layout belongs to continuous distribution. A pixel value of the binary mask layout is 0 or 1. To be specific, the binary mask layout belongs to discrete distribution. In some embodiments, 0 represents being transparent, and 1 represents being non-transparent. It can be seen based on the foregoing content that there is an error between the continuous distribution of the reference mask layout and the discrete distribution of the binary mask layout. The second reference sub-loss may be determined based on the reference mask layout according to the following formula (7), to reflect the error between the continuous distribution of the reference mask layout and the discrete distribution of the binary mask layout through the second reference sub-loss.

$$R_D = \frac{1}{L} \sum_{x=1}^{N} \sum_{y=1}^{N} [1 - (1 - 2M(x, y))^2] \qquad \text{Formula (7)}$$

where $R_D$ represents the second reference sub-loss. M (x, y) represents the reference mask layout, where x and y represent the parameters of the reference mask layout. The reference mask layout includes at least one geometrical pattern. A sum of perimeters of the geometrical patterns is used as the edge length of the reference mask layout, and L represents the edge length of the reference mask layout. N represents a side length of the reference mask layout. To be specific, the reference mask layout is a square with a side length of N.

For example, difference information between the sample chip layout and the initial mask layout is directly calculated. The difference information is recorded as second difference information. The third reference sub-loss is determined based on the second difference information. For example, the initial mask layout is first activated, to obtain a reference mask layout, difference information between the sample chip layout and the reference mask layout is then calculated, the difference information is recorded as second difference information, and the third reference sub-loss is determined based on the second difference information. For example, the difference information between the two layouts (the sample chip layout and the initial mask layout, or the sample chip layout and the reference mask layout) may be calculated based on a difference between pixel values of corresponding pixels in the two layouts. For example, a mean square error between the pixel values of the corresponding pixels in the two layouts is used as the difference information between the two layouts.

Usually, many tiny structures are generated in the process of performing mask optimization based on pixel features. In other words, there is a structural difference between the sample chip layout and the reference mask layout (or the initial mask layout). Since there is a structural difference between the reference mask layout and the sample chip layout, complexity of the reference mask layout is improved, making it difficult to manufacture the reference mask layout due to high complexity. Therefore, the third reference sub-loss may be determined based on the second difference information, to measure the complexity of the reference mask layout through the third reference sub-loss. In some embodiments, the third reference sub-loss is determined according to the following formula (8).

$$R_{TV} = \frac{1}{L}\left(\left\|\frac{\partial f}{\partial x}\right\|_1 + \left\|\frac{\partial f}{\partial y}\right\|_1\right) = \frac{1}{L}(\|D\oplus f\|_1 + \|f\oplus D^T\|_1)$$

$$f = |M - Z_t| \qquad \text{Formula (8)}$$

where M represents the reference mask layout, $Z_t$ represents the sample chip layout, and f represents the second difference information. $R_{TV}$ represents the third reference sub-loss. L represents the edge length of the sample chip layout. $\frac{\partial f}{\partial x}$ represents a first derivative of the second difference information relative to x, $\frac{\partial f}{\partial y}$ represents a first derivative of the second difference information relative to y, and x and y represent the parameters of the sample chip layout or the parameters of the reference mask layout. $\|\ \|_1$ represents a 1-norm. D represents a first derivative of the second difference information, T represents a transposed matrix, and $\oplus$ represents matrix addition.

In this embodiment of the present disclosure, the edge of the sample chip layout may be modified, to obtain edge modification information. In some embodiments, the edge of the sample chip layout is modified according to an edge modification distance and an edge modification amplitude, to obtain the edge modification information. The edge modification information includes multiple pieces of modification information, and any piece of modification information includes position information of multiple pixels. A distance between two adjacent pieces of modification information is the edge modification distance, and an amplitude of any piece of modification information is the edge modification amplitude. For example, the edge modification distance is 40 nm, and the edge modification amplitude is 30 nm.

Refer to FIG. 3. FIG. 3 is a schematic diagram of an edge modification information according to an embodiment of the present disclosure. A thick line in FIG. 3 represents the edge of the sample chip layout, and a thin line on the edge represents the modification information. Any piece of modification information includes position information of each pixel on the corresponding thin line. The edge modification distance is a distance between two adjacent pieces of modification information, i.e. a distance between two adjacent thin lines. The edge modification amplitude is an amplitude of any piece of modification information, i.e. a length of any thin line.

By modifying the edge of the sample chip layout, noise is introduced into the sample chip layout, and the complexity of the sample chip layout is reduced, so that the mask layout and the wafer layout can more easily approach the sample chip layout, thereby helping to improve generalization capability and accuracy of the model for determining a mask layout.

For example, the fourth reference sub-loss is determined based on the first difference information between the sample chip layout and the second wafer layout and the edge modification information, and the error between the sample chip layout and the second wafer layout in a case that noise exists in the sample chip layout is described through the fourth reference sub-loss. In some embodiments, the fourth reference sub-loss is determined according to the following formula (9).

$$L_{Aerial-MEPE} = \frac{1}{L}\sum_{x=1}^N \sum_{y=1}^N MEPE\odot(Z(x,y;h_\mu,t_q) - Z_t(x,y))^\gamma \qquad \text{Formula (9)}$$

where $L_{Aerial\text{-}MEPE}$ represents the fourth reference sub-loss. L represents the edge length of the sample chip layout. Z(x, y; $h_\mu$, $t_q$) - Zt(x, y) represents the first difference information. Zt(x, y) represents the sample chip layout, where x and y represent the parameters of the sample chip layout. N represents the side length of the sample chip layout. Z(x, y; $h_\mu$, $t_q$) represents the second wafer layout, $h_\mu$ represents the distance between the wafer and the focal plane of the lithography machine, and $t_q$ represents the exposure dose deviation of the lithography machine. $\gamma$ is an adjustable parameter. A modified edge placement error (MEPE) is the edge modification information. $\odot$ represents multiplication of corresponding elements of a matrix.

For example, the fifth reference sub-loss is directly determined based on the initial mask layout and the edge modification information. For example, the initial mask layout is first activated, to obtain a reference mask layout, and the fifth reference sub-loss is then determined based on the reference mask layout and the edge modification information. In an exemplary embodiment, the fifth reference sub-loss may be determined based on the reference mask layout and the edge modification information according to the following formula (10), to reflect, through the fifth reference sub-loss, the error between the continuous distribution of the reference mask layout and the discrete distribution of the binary mask layout in a case that the reference mask layout has the same noise as that of the sample chip layout.

$$R_{D-MEPE} = \frac{1}{L}\sum_{x=1}^{N}\sum_{y=1}^{N}[1 - (1 - 2M(x,y)\odot MEPE)^2] \quad \text{Formula (10)}$$

where $R_{D\text{-}MEPE}$ represents the fifth reference sub-loss. M(x, y) represents the reference mask layout, where x and y represent the parameters of the reference mask layout. L represents the edge length of the reference mask layout. N represents the side length of the reference mask layout. MEPE is the edge modification information. $\odot$ represents multiplication of corresponding elements of a matrix.

For example, the sixth reference sub-loss is determined based on the second difference information and the edge modification information, to measure, through the sixth reference sub-loss, the complexity of the reference mask layout in a case that the reference mask layout has the same noise as that of the sample chip layout. In some embodiments, the sixth reference sub-loss is determined according to the following formula (11).

$$R_{TV-MEPE} = \frac{1}{L}\left(\left\|\frac{\partial f\odot MEPE}{\partial x}\right\|_1 + \left\|\frac{\partial f\odot MEPE}{\partial y}\right\|_1\right)$$

$$= \frac{1}{L}(\|D\oplus(f\odot MEPE)\|_1 + \|(f\odot MEPE)\oplus D^T\|_1)$$

$$f = |M - Z_t| \quad \text{Formula (11)}$$

where M represents the reference mask layout, Zt represents the sample chip layout, and f represents the second difference information. $R_{TV\text{-}MEPE}$ represents the sixth reference sub-loss. L represents the edge length of the sample chip layout. MEPE is the edge modification information. $\odot$ represents multiplication of corresponding elements of a matrix. $\frac{\partial f\odot MEPE}{\partial x}$ represents a first-order derivative of a product of the second difference information and the edge modification information relative to x, $\frac{\partial f\odot MEPE}{\partial y}$ represents a first derivative of the product of the second difference information and the edge modification information relative to y, and x and y represent the parameters of the sample chip layout or the parameters of the reference mask layout. $\|\ \|_1$ represents a 1-norm. D represents a first derivative of the second difference information, T represents a transposed matrix, and $\oplus$ represents matrix addition.

The foregoing describes respective obtaining modes for the second reference sub-loss, the third reference sub-loss, the fourth reference sub-loss, the fifth reference sub-loss, and the sixth reference sub-loss. During an actual application, one or more reference sub-losses may be selected from the second reference sub-loss, the third reference sub-loss, the fourth reference sub-loss, the fifth reference sub-loss, and the sixth reference sub-loss according to a requirement, and the selected reference sub-loss is obtained according to the obtaining modes described above.

Operation A322: Determine the reference loss based on the first reference sub-loss and at least one of the second reference sub-loss, the third reference sub-loss, the fourth reference sub-loss, the fifth reference sub-loss, or the sixth reference sub-loss.

For example, weighted summation is performed on the first reference sub-loss and at least one of the second reference sub-loss, the third reference sub-loss, the fourth reference sub-loss, the fifth reference sub-loss, and the sixth reference sub-loss. The reference loss is determined based on a weighted summation result. For any two reference sub-losses in the first reference sub-loss to the sixth reference sub-loss, weights of the two reference sub-losses may be the same or may be different.

In some embodiments, the reference loss is determined according to the following formula (12).

$$L_{MEPE} = L_{Aerial-MEPE} + \alpha_1 R_{D-MEPE} + \kappa_1 R_{TV-MEPE}$$

$$L_{total} = \sum_{\mu}^{U} \sum_{q}^{Q} \xi(h_{\mu})\zeta(t_q)(L_{Aerial} + \alpha_2 R_D + \kappa_2 R_{TV} + \beta L_{MEPE}) \quad \text{Formula (12)}$$

where $L_{total}$ represents the reference loss. $L_{Aerial}$ represents the first reference sub-loss. $R_D$ represents the second reference sub-loss, and $\alpha_2$ represents the weight of the second reference sub-loss. $R_{TV}$ represents the third reference sub-loss, and $\kappa_2$ represents the weight of the third reference sub-loss. $L_{MEPE}$ represents the sub-loss corresponding to the edge modification information, and $\beta$ represents the weight of the sub-loss corresponding to the edge modification information. $L_{Aerial-MEPE}$ represents the fourth reference sub-loss, and the weight of the fourth reference sub-loss is $\beta$. $R_{D-MEPE}$ represents the fifth reference sub-loss, $\alpha_1$ represents a sub-weight of the fifth reference sub-loss, and a product of the sub-weight of the fifth reference sub-loss and the weight of the sub-loss corresponding to the edge modification information is the weight of the fifth reference sub-loss. To be specific, $\alpha_1\beta$ represents the weight of the fifth reference sub-loss. $R_{TV-MEPE}$ represents the sixth reference sub-loss, $\kappa_1$ represents a sub-weight of the sixth reference sub-loss, and a product of the sub-weight of the sixth reference sub-loss and the weight of the sub-loss corresponding to the edge modification information is the weight of the sixth reference sub-loss. To be specific, $\kappa_1\beta$ represents the weight of the sixth reference sub-loss. $\xi(h_{\mu})$ represents the defocus process parameter distribution function, and $\zeta(t_q)$ represents the exposure dose deviation process parameter distribution function.

There is at least one $h_{\mu}$, $\mu$ represents a sequence number, and U represents a quantity of $h_{\mu}$. For example, for the reference lithography process parameter, $h_{\mu} = 0$. In this case, U=1. For a second lithography process parameter which is an actual lithography process parameter, a value of $h_{\mu}$ may be -80, 0, or 80. In this case, U=3. Similarly, there is at least one $t_q$, q represents a sequence number, and Q represents the quantity of $t_q$. For example, for the reference lithography process parameter, $t_q = 0$. In this case, Q=1. For a second lithography process parameter which is an actual lithography process parameter, a value of $t_q$ may be -0.1, 0, or 0.1. In this case, Q=3.

The weight and sub-weight of each reference sub-loss are not limited in this embodiment of the present disclosure. For example, the weight of the second reference sub-loss and the sub-weight of the fifth reference sub-loss are the same, i.e. $\alpha_1 = \alpha_2 = \alpha$. The weight of the third reference sub-loss and the sub-weight of the sixth reference sub-loss are the same, i.e. $\kappa_1 = \kappa_2 = \kappa$. Relative values of the reference sub-losses are balanced through the weights of the reference sub-losses. Therefore, the weights of the reference sub-losses are adjustable parameters. For example, $\alpha = 0.025$, $\kappa = 0.06$, $\beta = 2$.

Operation A33: Determine a first gradient of the reference loss relative to the initial mask layout.

In this embodiment of the present disclosure, the reference loss includes the first reference sub-loss and at least one of the second reference sub-loss to the sixth reference sub-loss. Therefore, the first gradient of the reference loss relative to the initial mask layout includes two parts. The first part is a gradient of the at least one reference sub-loss among the second reference sub-loss to the sixth reference sub-loss relative to the initial mask layout. The second part is a gradient of the first reference sub-loss relative to the initial mask layout.

An example in which the reference loss includes the first reference sub-loss to the sixth reference sub-loss is used. The first gradient of the reference loss relative to the initial mask layout is shown in the following formula (13).

$$\frac{\partial L_{total}}{\partial \overline{M}} = \sum_{\mu}^{U} \sum_{q}^{Q} \xi(h_{\mu})\zeta(t_q)\left(\frac{\partial L_{Aerial}}{\partial \overline{M}} + \alpha \frac{\partial R_D}{\partial \overline{M}} + \kappa \frac{\partial R_{TV}}{\partial \overline{M}} + \beta \frac{\partial L_{Aerial-MEPE}}{\partial \overline{M}} + \right.$$

$$\left. \alpha\beta \frac{\partial R_{D-MEPE}}{\partial \overline{M}} + \kappa\beta \frac{\partial R_{TV-MEPE}}{\partial \overline{M}}\right) \quad \text{Formula (13)}$$

where $\frac{\partial L_{total}}{\partial \overline{M}}$ represents the first gradient of the reference loss relative to the initial mask layout. $\xi(h_{\mu})$ represents the defocus process parameter distribution function, and $\zeta(t_q)$ represents the exposure dose deviation process parameter distribution function. $\frac{\partial L_{Aerial}}{\partial \overline{M}}$ represents the gradient of the first reference sub-loss relative to the initial mask layout.

$\frac{\partial R_D}{\partial \overline{M}}$ represents the gradient of the second reference sub-loss relative to the initial mask layout, and $\alpha$ represents the weight of the second reference sub-loss. $\frac{\partial R_{TV}}{\partial \overline{M}}$ represents the gradient of the third reference sub-loss relative to the initial mask layout, and $\kappa$ represents the weight of the third reference sub-loss. $\frac{\partial L_{Aerial-MEPE}}{\partial \overline{M}}$ represents the gradient of the fourth reference sub-loss relative to the initial mask layout, and $\beta$ represents the weight of the fourth reference sub-loss.

$\frac{\partial R_{D-MEPE}}{\partial \overline{M}}$ represents the gradient of the fifth reference sub-loss relative to the initial mask layout, and $\alpha\beta$ represents the weight of the fifth reference sub-loss. $\frac{\partial R_{TV-MEPE}}{\partial \overline{M}}$ represents the gradient of the sixth reference sub-loss relative to the initial mask layout, and $\kappa\beta$ represents the weight of the sixth reference sub-loss.

In this embodiment of the present disclosure, the following formula (14) exists. The principle of formula (14) is the same as that of formula (3) mentioned above. In formula (3), $M_0$ represents the reference mask layout, and $\overline{M}_0$ represents the initial mask layout. In formula (14), M represents the reference mask layout, and $\overline{M}$ represents the initial mask layout. In other words, M in formula (14) is equivalent to $M_0$ in formula (3), and $\overline{M}$ in formula (14) is equivalent to $\overline{M}_0$ in formula (3).

$$M = \frac{1}{1+\exp(-\theta_M \times (\overline{M}-M_{th}))} \qquad \text{Formula (14)}$$

where M represents the reference mask layout, exp represents the exponential function with the natural constant e as the base, $\theta_M$ and $M_{th}$ represent activation processing parameters, and $\overline{M}$ represents the initial mask layout. For example, $\theta_M = 4$, $M_{th} = 0.225$.

For the gradient of the first reference sub-loss relative to the initial mask layout in formula (13), the following formula (15) may be obtained based on formula (14).

$$\frac{\partial L_{Aerial}}{\partial \overline{M}} = \frac{1}{L}\gamma(Z - Z_t)^{\gamma-1} \odot \frac{\partial Z}{\partial M} \odot \frac{\partial M}{\partial \overline{M}}$$

$$= \frac{1}{L}\gamma\theta_M\theta_Z\{H^{flip}\otimes[(Z - Z_t)^{\gamma-1}\odot Z\odot(1 - Z)\odot(M\otimes H^*)] + (H^{flip})^*\otimes[(Z -$$

$$Z_t)^{\gamma-1}\odot Z\odot(1 - Z)\odot(M\otimes H)]\}\odot M\odot(1 - M) \qquad \text{Formula (15)}$$

where $\frac{\partial L_{Aerial}}{\partial \overline{M}}$ represents the gradient of the first reference sub-loss relative to the initial mask layout. L represents the edge length of the sample chip layout. $\gamma$ is an adjustable parameter. Z - Zt represents the first difference information, Zt represents the sample chip layout, and Z represents the second wafer layout. $\frac{\partial Z}{\partial M}$ represents the gradient of the second wafer layout relative to the reference mask layout. $\frac{\partial M}{\partial \overline{M}}$ represents the gradient of the reference mask layout relative to the initial mask layout. $\odot$ represents multiplication of corresponding elements of a matrix. $\theta_M$ and $\theta_Z$ are both activation processing parameters. For example, $\theta_M = 4$, $\theta_Z = 50$. $H^{flip}$ represents a function obtained by flipping the kernel function H by 180o, where the kernel functions are obtained by performing singular value decomposition on the cross transfer coefficient of the lithography system. $\otimes$ represents the function sign of the convolution processing. $H^*$ represents a complex conjugate of the kernel function H, and $(H^{flip})^*$ represents a complex conjugate of the function $H^{flip}$. M represents the reference mask layout, and $\overline{M}$ represents the initial mask layout.

For the gradient of the second reference sub-loss relative to the initial mask layout in formula (13), the following formula (16) may be obtained based on formula (14).

$$\frac{\partial R_D}{\partial \overline{M}} = \frac{\partial R_D}{\partial M} \odot \frac{\partial M}{\partial \overline{M}} = \frac{1}{L}\theta_M(-8 \times M + 4)\odot M\odot(1 - M) \qquad \text{Formula (16)}$$

where $\frac{\partial R_D}{\partial \overline{M}}$ represents the gradient of the second reference sub-loss relative to the initial mask layout. $\frac{\partial R_D}{\partial M}$ represents the gradient of the second reference sub-loss relative to the reference mask layout. $\frac{\partial M}{\partial \overline{M}}$ represents the gradient of the reference mask layout relative to the initial mask layout. $\odot$ represents multiplication of corresponding elements of a matrix. L represents the edge length of the reference mask layout, $\theta_M$ is the activation processing parameter, and M represents the reference mask layout.

For the gradient of the third reference sub-loss relative to the initial mask layout in formula (13), the following formula (17) may be obtained based on formula (14).

$$\frac{\partial R_{TV}}{\partial \overline{M}} = \frac{\partial R_{TV}}{\partial f} \odot \frac{\partial f}{\partial M} \odot \frac{\partial M}{\partial \overline{M}}$$

$$= \frac{1}{L}\theta_M[D^T\oplus\text{sign}(D\oplus f) + \text{sign}(f\oplus D^T)\oplus D]\odot\text{sign}(M - Z_t)\odot M\odot(1 - M)$$

Formula (17)

where $\frac{\partial R_{TV}}{\partial \overline{M}}$ represents the gradient of the third reference sub-loss relative to the initial mask layout. $\frac{\partial R_{TV}}{\partial f}$ represents the gradient of the third reference sub-loss relative to the second difference information. $\frac{\partial f}{\partial M}$ represents the gradient of the second difference information relative to the reference mask layout. $\frac{\partial M}{\partial \overline{M}}$ represents the gradient of the reference mask layout relative to the initial mask layout. $\odot$ represents multiplication of corresponding elements of a matrix. L represents the edge length of the sample chip layout, $\theta_M$ is the activation processing parameter, D represents the first-order derivative of the second difference information, T represents the transposed matrix, $\oplus$ represents the matrix addition, f represents the second difference information, M represents the reference mask layout, and Zt represents the sample chip layout. sign is a sign function, where the sign function satisfies: sign(x)=0, x=0; sign(x)=1, x>0; sign(x)=-1, x<0.

For the gradient of the fourth reference sub-loss relative to the initial mask layout in formula (13), the following formula (18) may be obtained based on formula (14).

$$\frac{\partial L_{Aerial-MEPE}}{\partial \overline{M}} = \frac{\partial L_{Aerial}}{\partial \overline{M}} \odot MEPE \qquad \text{Formula (18)}$$

where $\frac{\partial L_{Aerial-MEPE}}{\partial \overline{M}}$ represents the gradient of the fourth reference sub-loss relative to the initial mask layout. $\frac{\partial L_{Aerial}}{\partial \overline{M}}$ represents the gradient of the first reference sub-loss relative to the initial mask layout. MEPE is the edge modification information. $\odot$ represents multiplication of corresponding elements of a matrix.

For the gradient of the fifth reference sub-loss relative to the initial mask layout in formula (13), the following formula (19) may be obtained based on formula (14).

$$\frac{\partial R_{D-MEPE}}{\partial \overline{M}} = \frac{\partial RM_{D-MEPE}}{\partial M} \odot \frac{\partial M}{\partial \overline{M}} = \frac{1}{L} \times \theta_M(-8 \times MEPE\odot M + 4)\odot M\odot(1 - M)$$

Formula (19)

where $\dfrac{\partial R_{D-MEPE}}{\partial \overline{M}}$ represents the gradient of the fifth reference sub-loss relative to the initial mask layout. $\dfrac{\partial RM_{D-MEPE}}{\partial M}$ represents the gradient of the fifth reference sub-loss relative to the reference mask layout. $\dfrac{\partial M}{\partial \overline{M}}$ represents the gradient of the reference mask layout relative to the initial mask layout. $\odot$ represents multiplication of corresponding elements of a matrix. L represents the edge length of the reference mask layout. $\theta_M$ is the activation processing parameter, MEPE is the edge modification information, and M represents the reference mask layout.

For the gradient of the sixth reference sub-loss relative to the initial mask layout in formula (13), the following formula (20) may be obtained based on formula (14).

$$\frac{\partial R_{TV-MEPE}}{\partial \overline{M}} = \frac{\partial R_{TV-MEPE}}{\partial f} \odot \frac{\partial f}{\partial M} \odot \frac{\partial M}{\partial \overline{M}}$$

$$= \frac{1}{L}\theta_M[D^T \oplus \text{sign}(D \oplus (MEPE \odot f)) + \text{sign}((MEPE \odot f) \oplus D^T) \oplus D] \odot \text{sign}(M - Z_t) \odot M \odot (1 - M) \quad \text{Formula (20)}$$

where $\dfrac{\partial R_{TV-MEPE}}{\partial \overline{M}}$ represents the gradient of the sixth reference sub-loss relative to the initial mask layout. $\dfrac{\partial R_{TV-MEPE}}{\partial f}$ represents the gradient of the sixth reference sub-loss relative to the second difference information. $\dfrac{\partial f}{\partial M}$ represents the gradient of the second difference information relative to the reference mask layout. $\dfrac{\partial M}{\partial \overline{M}}$ represents the gradient of the reference mask layout relative to the initial mask layout. $\odot$ represents multiplication of corresponding elements of a matrix. L represents the edge length of the sample chip layout, $\theta_M$ is the activation processing parameter, D represents the first-order derivative of the second difference information, T represents the transposed matrix, $\oplus$ represents the matrix addition, MEPE is the edge modification information, f represents the second difference information, M represents the reference mask layout, and Zt represents the sample chip layout. sign is the sign function.

Formula (13) includes the gradient of the first reference sub-loss to the sixth reference sub-loss relative to the initial mask layout. Since the reference loss includes the first reference sub-loss and the at least one of the second reference sub-loss to the sixth reference sub-loss, the first gradient of the reference loss relative to the initial mask layout includes: a gradient of the at least one of the second reference sub-loss to the sixth reference sub-loss relative to the initial mask layout and a gradient of the first reference sub-loss relative to the initial mask layout. Details are not described herein again.

Operation A34: Adjust the initial mask layout based on the first gradient, to obtain the labeled mask layout.

For example, according to a steepest descent method or a conjugate gradient method, a reference gradient is determined based on the first gradient, and the initial mask layout is adjusted based on the reference gradient. For the operation of "determining a reference gradient based on the first gradient", there are different implementations of the steepest descent method and the conjugate gradient method. The two implementations are respectively described below.

In the steepest descent method, the first gradient may be determined as the reference gradient. For example, the reference gradient is determined according to the following formula (21).

$$V_k = g_k = \frac{\partial L_{total}}{\partial \overline{M}_k} \quad \text{Formula (21)}$$

where $V_k$ represents a reference gradient corresponding to a $k^{th}$ iteration. $g_k$ represents a first gradient corresponding to the $k^{th}$ iteration, and $\dfrac{\partial L_{total}}{\partial \overline{M}_k}$ represents a first gradient of the reference loss relative to a mask layout corresponding to the $k^{th}$ iteration. The initial mask layout corresponds to a mask layout corresponding to iteration 0, optimization corresponding to iteration 0 is performed on the initial mask layout, and there is at least one iteration. It can be seen from formula (21) that for the steepest descent method, an optimization direction of the initial mask layout is a direction of the first gradient.

In the conjugate gradient method, for iteration 0, the first gradient is the reference gradient. For any iteration other than iteration 0, a conjugate gradient factor corresponding to the current iteration is first determined based on a first gradient corresponding to the current iteration and a first gradient corresponding to a previous iteration, where the conjugate gradient factor is in negative correlation with a weight of a reference gradient corresponding to the previous iteration. Next, a reference gradient corresponding to the current iteration is determined based on the first gradient corresponding to the current iteration, the conjugate gradient factor corresponding to the current iteration, and the reference gradient corresponding to the previous iteration. In some embodiments, the reference gradient is determined according to the following formula (22).

$$V_k = g_k = \frac{\partial L_{total}}{\partial \overline{M}_k}, k = 0$$

$$V_k = g_k - \eta_k V_{k-1}, k > 0$$

$$\eta_k = \frac{\|g_k\|^2 - \sum g_k \cdot g_{k-1}}{\|g_{k-1}\|^2} \qquad \text{Formula (22)}$$

where $V_k$ represents a reference gradient corresponding to the $k^{th}$ iteration, and $V_{k-1}$ represents a reference gradient corresponding to a $(k-1)^{th}$ iteration. $g_k$ represents the first gradient corresponding to the $k^{th}$ iteration, and $g_{k-1}$ represents a first gradient corresponding to the $(k-1)^{th}$ iteration. $\frac{\partial L_{total}}{\partial \overline{M}_k}$ represents the first gradient of the reference loss relative to the mask layout corresponding to the $k^{th}$ iteration. $\eta_k$ represents a conjugate gradient factor corresponding to the $k^{th}$ iteration.

The initial mask layout corresponds to a mask layout corresponding to iteration 0, optimization corresponding to iteration 0 is performed on the initial mask layout, and there is at least one iteration. It can be seen from formula (22) that for the conjugate gradient method, the optimization direction of the initial mask layout is the direction of the first gradient. For all subsequent optimization directions when the mask layout is optimized, refer to the previous optimization direction, and the conjugate gradient factor is adaptively adjusted. By automatically adjusting the conjugate gradient factor, stagnation of optimization can be avoided, and an optimization effect can be improved, thus helping to improve the accuracy of the labeled mask layout.

In an exemplary embodiment, operation A34 includes operations A341 to A343 (not shown).

Operation A341: Determine an adjustment step based on the first gradient.

In this embodiment of the present disclosure, the reference gradient may be determined based on the first gradient according to the steepest descent method or the conjugate gradient method, and the adjustment step of the initial mask layout may be determined based on the reference gradient. In some embodiments, the adjustment step is determined according to the following formula (23).

$$\omega_k = \frac{\varepsilon}{\max(|V_k|)} \qquad \text{Formula (23)}$$

where $\omega_k$ represents an adjustment step corresponding to the $k^{th}$ iteration. $\varepsilon$ represents a step factor. For example, $\varepsilon = 0.1$. max represents a function sign of a maximum function, and $V_k$ represents the reference gradient corresponding to the $k^{th}$ iteration.

Operation A342: Adjust the initial mask layout based on the adjustment step and the first gradient, to obtain an adjusted mask layout.

For example, the adjustment step and the first gradient are multiplied, to obtain a product result. The initial mask layout is adjusted based on the product result, to obtain the adjusted mask layout. In some embodiments, the adjusted mask layout is determined according to the following formula (24).

$$\overline{M}_{k+1} = \overline{M}_k - \omega_k V_k \qquad \text{Formula (24)}$$

where $\overline{M}_{k+1}$ represents a mask layout corresponding to a $(k+1)^{th}$ iteration, and $\overline{M}_k$ represents the mask layout corresponding to the $k^{th}$ iteration. $\omega_k$ represents the adjustment step corresponding to the $k^{th}$ iteration. $V_k$ represents the reference gradient corresponding to the $k^{th}$ iteration. When k=0, a mask layout corresponding to iteration 0 is the initial mask layout, and a mask layout corresponding to iteration 1 is the adjusted mask layout.

Operation A343: Activate the adjusted mask layout in a case that the adjusted mask layout satisfies an adjustment ending condition, to obtain the labeled mask layout.

Content of the adjusted mask layout satisfying the adjustment ending condition is not limited in this embodiment of the present disclosure. For example, the case that the adjusted mask layout satisfies the adjustment ending condition is: The quantity of iterations corresponding to the adjusted mask layout reaches a first set quantity, or the first gradient (or the reference gradient) corresponding to the adjusted mask layout reaches a set gradient. The first set quantity and the set gradient are set according to experience, or are flexibly adjusted according to an application requirement. This is not limited in this embodiment of the present disclosure.

If the adjusted mask layout satisfies the adjustment ending condition, the adjusted mask layout is activated through the activation function, to obtain an activated mask layout. In some embodiments, the activation function is a sigmoid function. The activated mask layout is determined according to the following formula (25). The principle of formula (25) is the same as those of formula (3) and formula (14) mentioned above. $M_{k+1}$ in formula (25) is equivalent to M in formula (14) and $M_0$ in formula (3), and $\overline{M}_{k+1}$ in formula (25) is equivalent to $\overline{M}$ in formula (14) and $\overline{M}_0$ in formula (3).

$$M_{k+1} = \frac{1}{1+\exp(-\theta_M \times (\overline{\overline{M}_{k+1}} - M_{th}))} \qquad \text{Formula (25)}$$

where $M_{k+1}$ represents an activated mask layout corresponding to the $(k+1)^{th}$ iteration. exp represents the exponential function with the natural constant e as the base. $\theta_M$ and $M_{th}$ represent activation processing parameters. $\overline{M}_{k+1}$ represents the mask layout corresponding to the $(k+1)^{th}$ iteration.

Since a pixel value of the mask layout corresponding to the $(k+1)^{th}$ iteration may be greater than 1 or less than 0, the pixel value may be fixed between 0 and 1 through the sigmoid function. To be specific, a pixel value of the labeled mask layout is between 0 and 1.

Next, the activated mask layout is binarized, to obtain the labeled mask layout. In some embodiments, the labeled mask layout is determined according to the following formula (26).

$$M_{bin}(\text{x}, \text{y}) = 0, M(\text{x}, \text{y}) \leq M_t$$

$$M_{bin}(\text{x}, \text{y}) = 1, M(\text{x}, \text{y}) > M_t \qquad \text{Formula (26)}$$

where $M_{bin}(\text{x}, \text{y})$ represents the labeled mask layout, and the pixel value on the labeled mask layout is 0 or 1. $M(\text{x}, \text{y})$ represents the activated mask layout. Mt represents a pixel threshold. The pixel threshold may be set according to experience, or may be flexibly adjusted according to an application requirement. This is not limited in this embodiment of the present disclosure. In some embodiments, the pixel threshold is 0.5.

It can be seen from formula (26) that if any pixel value in the activated mask layout is less than or equal to the pixel threshold, the pixel value is set to 0. If any pixel value in the activated mask layout is greater than the pixel threshold, the pixel value is set to 1. By using the foregoing mode of binarizing each pixel value in the activated mask layout, the labeled mask layout may be obtained.

In some embodiments, after operation A342, the method further includes operations A344 to A345 (not shown).

Operation A344: Determine a third wafer layout of the adjusted mask layout through the second wafer layout determining model in a case that the adjusted mask layout does not satisfy the adjustment ending condition, where the third wafer layout is a wafer layout of the adjusted mask layout obtained by prediction under the conditions of the reference lithography process parameter.

If the adjusted mask layout does not satisfy the adjustment ending condition, based on an implementation principle of operation A2, the third wafer layout of the adjusted mask layout is determined through the second wafer layout determining model. The adjusted mask layout in operation A344 corresponds to the initial mask layout in operation A2. The third wafer layout in operation A344 corresponds to the second wafer layout in operation A2. Since an implementation principle of operation A344 is similar to the implementation principle of operation A2, refer to the foregoing descriptions for operation A2. Details are not described herein again.

Operation A345: Adjust the adjusted mask layout based on the sample chip layout and the third wafer layout, to obtain the labeled mask layout.

For example, based on an implementation principle of operation A3, the adjusted mask layout is adjusted based on the sample chip layout and the third wafer layout, to obtain the labeled mask layout. The adjusted mask layout in operation A345 corresponds to the initial mask layout in operation A3. The third wafer layout in operation A345 corresponds to the second wafer layout in operation A3. Since an implementation principle of operation A345 is similar to the implementation principle of operation A3, refer to the foregoing descriptions for operation A3. Details are not described herein again.

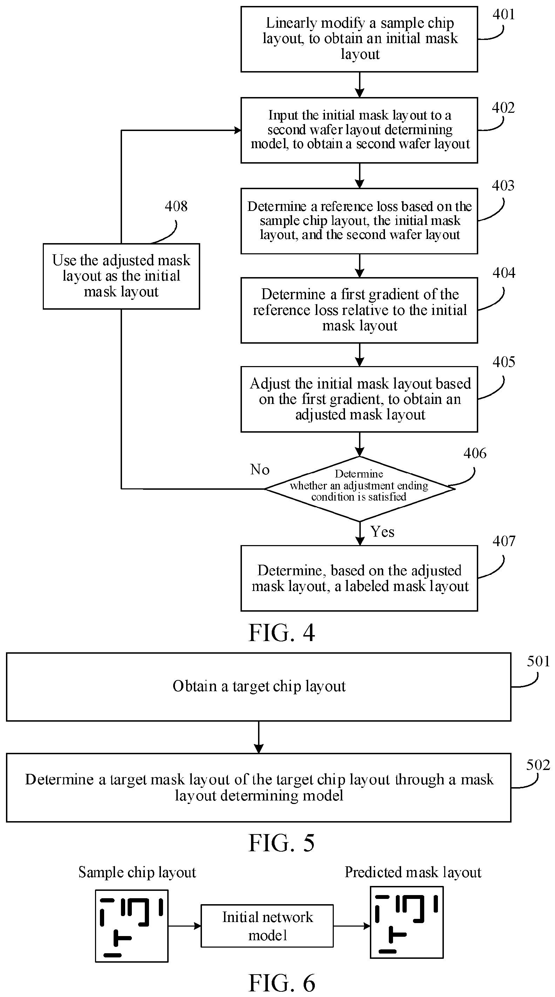

It can be seen from content of operations A1 to A3 that, in this embodiment of the present disclosure, the initial mask layout is iteratively adjusted based on the second wafer layout determining model of the reference lithography process parameter, to obtain the labeled mask layout. This adjustment process belongs to an inverse lithography technology (ILT). Refer to FIG. 4. FIG. 4 is a flowchart of determining a labeled mask layout according to an embodiment of the present disclosure. A procedure of determining the labeled mask layout includes the following operations 401 to 408.

Operation 401: Linearly modify a sample chip layout, to obtain an initial mask layout. For an implementation of operation 401, refer to the descriptions for operation A1. Details are not described herein again.

Operation 402: Input the initial mask layout to a second wafer layout determining model, to obtain a second wafer layout. For an implementation of operation 402, refer to the descriptions for operation A2. Details are not described herein again.

Operation 403: Determine a reference loss based on the sample chip layout, the initial mask layout, and the second wafer layout. For an implementation of operation 403, refer to the descriptions for operations A31 to A32. Details are not described herein again.

Operation 404: Determine a first gradient of the reference loss relative to the initial mask layout. For an implementation of operation 404, refer to the descriptions for operation A33. Details are not described herein again.

Operation 405: Adjust the initial mask layout based on the first gradient, to obtain an adjusted mask layout. For an implementation of operation 405, refer to the descriptions for operations A341 to A342. Details are not described herein again.

Operation 406: Determine whether the adjusted mask layout satisfies an adjustment ending condition.

Operation 407: Determine, based on the adjusted mask layout, a labeled mask layout if the adjusted mask layout satisfies the adjustment ending condition. For an implementation of operation 407, refer to the descriptions for operation A343. Details are not described herein again.

Operation 408: Use the adjusted mask layout as the initial mask layout if the adjusted mask layout does not satisfy the adjustment ending condition. Next, operation 402 and subsequent operations are performed, until the adjusted mask layout satisfies the adjustment ending condition and the labeled mask layout is determined based on the adjusted mask layout.

In this embodiment of the present disclosure, the initial mask layout is optimized step by step through the second wafer layout determining model, to obtain the labeled mask layout, so that the labeled mask layout is determined based on a deep learning method, a calculation amount of determining the labeled mask layout is reduced, and efficiency of determining the labeled mask layout is improved.

When training the mask layout determining model, the electronic device may obtain the labeled mask layout in real time through the foregoing operations A1 to A3. The electronic device may alternatively obtain and store the labeled mask layout through the foregoing operations A1 to A3 before training the mask layout determining model, so as to extract the labeled mask layout from storage when training the mask layout determining model. The electronic device may alternatively obtain the labeled mask layout from other devices when training the mask layout determining model. The other devices are configured to obtain and store the labeled mask layout through the foregoing operations A1 to A3 before the electronic device trains the mask layout determining model.

Operation 202: Determine a predicted mask layout of the sample chip layout through a neural network model.

The predicted mask layout is a mask layout of the sample chip layout obtained by prediction.

For example, the sample chip layout is inputted to the neural network model, and the predicted mask layout is determined through the neural network model. For example, the neural network model is an initial or untrained network model, which is an initial or untrained model for determining a mask layout. In some embodiments, the initial network model is a U-net model, and the U-net model includes an encoder and a decoder. Functions of the encoder and the decoder are correspondingly described below. Details are not described herein again. Alternatively, the neural network model is obtained by pre-training the initial network model through the sample chip layout and the labeled mask layout. In some embodiments, the neural network model also includes an encoder and a decoder. However, there is a model parameter difference between the encoder included in the neural network model and the encoder included in the initial network model, and there is also a model parameter difference between the decoder included in the neural network model and the decoder included in the initial network model.

In the process of pre-training the initial network model through the sample chip layout and the labeled mask layout, the sample chip layout may be inputted to the initial network model, and the predicted mask layout is determined through the initial network model. A loss of the initial network model is determined based on difference information between the labeled mask layout and the predicted mask layout determined through the initial network model, and the model parameter of the initial network model is adjusted based on the loss of the initial network model, to obtain the adjusted initial network model.

If the adjusted initial network model satisfies a pre-training ending condition, the adjusted initial network model is used as the neural network model. If the adjusted initial network model does not satisfy the pre-training ending condition, the sample chip layout is inputted to the adjusted initial network model, and the predicted mask layout is determined through the adjusted initial network model. A loss of the initial network model is determined based on difference information between the labeled mask layout and the predicted mask layout determined through the adjusted initial network model, and the model parameter of the adjusted initial network model is adjusted again based on the loss of the initial network model. The rest can be deduced by analogy, until the adjusted initial network model satisfies the pre-training ending condition and the adjusted initial network model is used as the neural network model.

For example, the case that the adjusted initial network model satisfies the pre-training ending condition is: The quantity of trainings of the adjusted initial network model reaches a second set quantity, or the loss of the initial network model is within a first set range, or the loss of the initial network model converges. The second set quantity and the first set range are set according to experience, or are flexibly adjusted according to an application requirement. This is not limited in this embodiment of the present disclosure. The second set quantity may be the same as or different from the first set quantity.

The initial network model is pre-trained, so that not only the neural network model has a capability of determining the predicted mask layout based on the sample chip layout, but also a convergence speed of the neural network model can be increased and efficiency can be improved when the neural network model is subsequently trained.

Functions, structures, and the like of the initial network model and the neural network model are the same, and there is only a difference in model parameters between the two network models. Therefore, an implementation principle of determining the predicted mask layout of the sample chip layout through the initial network model is the same as an implementation principle of determining the predicted mask layout of the sample chip layout through the neural network model. Refer to the following descriptions for operations 2021 to 2022. In a possible implementation, operation 202 includes operations 2021 to 2022 (not shown).

Operation 2021: Encode the sample chip layout through the neural network model, to obtain a layout feature of the sample chip layout.

In this embodiment of the present disclosure, the neural network model is a U-net model, and the neural network model includes an encoder. The sample chip layout is encoded through the encoder, to obtain the layout feature of the sample chip layout.

In some embodiments, the encoder includes at least one convolutional neural network layer, and any convolutional neural network layer includes at least one filter. For example, the encoder includes eight convolutional neural network layers. The eight convolutional neural network layers respectively include 8, 16, 32, 64, 128, 256, 512, and 1024 $3\times3$ filters. For any convolutional neural network layer, the convolutional neural network layer may be followed by a batch normalization layer and an activation function layer. In some embodiments, the activation function layer is a function layer of a rectified linear unit (ReLU).

After the sample chip layout is inputted to the encoder, the sample chip layout is convolved through the convolutional neural network layers sequentially, and the layout feature of the sample chip layout is obtained based on a convolution processing result of the last convolutional neural network layer. In some embodiments, the sample chip layout is a matrix of (256, 256, 1) dimensions, and the layout feature of the sample chip layout is a matrix of (1, 1, 1024) dimensions. Certainly, the sample chip layout and the layout feature may alternatively be matrices in other dimensions. This is not limited in this embodiment of the present disclosure.

Operation 2022: Decode the layout feature of the sample chip layout through the neural network model, to obtain the predicted mask layout.

The neural network model further includes a decoder connected in series to the encoder. The layout feature of the sample chip layout is decoded through the decoder, to obtain the predicted mask layout.

In some embodiments, the decoder includes at least one deconvolutional neural network layer, and any deconvolutional neural network layer includes at least one filter. For example, the decoder includes eight deconvolutional neural network layers. The eight deconvolutional neural network layers respectively include 1024, 512, 256, 128, 64, 32, 16, and 1 $3\times3$ filter. For any deconvolutional neural network layer, the deconvolutional neural network layer may be followed by a batch normalization layer and/or an activation function layer. In some embodiments, the activation function layer is a function layer of a leaky rectified linear unit (Leaky-ReLU) or a function layer of a sigmoid activation function. For example, each of the first seven deconvolutional neural network layers is followed by the batch normalization layer and the function layer of the Leaky-ReLU, and the eighth deconvolutional neural network layer is followed by the function layer of the sigmoid activation function.

After the layout feature of the sample chip layout is inputted to the decoder, the sample chip layout is deconvolved through the deconvolutional neural network layers sequentially, and sigmoid activation processing is performed on a deconvolution processing result of the last convolutional neural network layer, to obtain the predicted mask layout. In some embodiments, the layout feature of the sample chip layout is a matrix of (1, 1, 1024) dimensions. The predicted mask layout is a matrix of (256, 256, 1) dimensions, and values in the matrix are values between 0 and 1. Certainly, the layout feature of the sample chip layout and the predicted mask layout may alternatively be matrices in other dimensions. This is not limited in this embodiment of the present disclosure.

Operation 203: Determine a first wafer layout of the predicted mask layout through a first wafer layout determining model.

The first wafer layout determining model includes a second lithography process parameter which is an actual lithography process parameter. The first wafer layout is a wafer layout of a predicted mask layout obtained by prediction under conditions of the actual lithography process parameter.

In an actual operation, in a process of exposing the labeled mask layout on the wafer through the lithography machine, the lithography machine may perform exposure based on any lithography process parameter. The lithography process parameter used when the lithography process is actually performed is an actual lithography process parameter. The actual lithography process parameter is a lithography process parameter used when the lithography process is actually performed.

In an exemplary embodiment, the actual lithography process parameter may be determined through a defocus process parameter distribution function and/or an exposure dose deviation process parameter distribution function. In the process of an actual lithography process, a distance between the wafer and the focal plane of the lithography machine may not be equal to 0. Based on this, for the actual lithography process, $h_\mu$ in formula (1) may be any data, and $\sigma_h$ may remain unchanged. For example, a value of $h_\mu$ may be [-80 nm, 0 nm, 80 nm], $\sigma_h = 80$. Furthermore, during an actual lithography process, an exposure dose deviation of the lithography machine may not be equal to 0. Based on this, $t_q$ in formula (2) may be any data, and $\sigma_q$ may remain unchanged. For example, a value of $t_q$ may be [-0.1, 0.0, 0.1], $\sigma_q = 0.1$.

It can be seen from the foregoing that the reference lithography process parameter is a set lithography process parameter. In some embodiments, the set lithography process parameter refers to: the wafer and the focal plane of the lithography machine are located in the same plane, and the exposure dose of the lithography machine has no deviation. The actual lithography process parameter is a lithography process parameter that is actually used. The lithography process parameter that is actually used includes: the wafer and the focal plane of the lithography machine are or not located in the same plane (the wafer is above or below the focal plane of the lithography machine), and the exposure dose of the lithography machine has a deviation or no deviation.

For example, the predicted mask layout is directly inputted to the first wafer layout determining model, and the first wafer layout is outputted through the first wafer layout determining model. Alternatively, the predicted mask layout is first activated, to obtain a reference mask layout, the reference mask layout is then inputted to the first wafer layout determining model, and the first wafer layout is outputted through the first wafer layout determining model. An implementation of operation 203 is similar to the implementation of operation A2, and may be seen from the descriptions for operation A2. Details are not described herein again.

The predicted mask layout in operation 203 corresponds to the initial mask layout in operation A2. The reference mask layout in operation 203 corresponds to the reference mask layout in operation A2. The first wafer layout determining model in operation 203 corresponds to the second wafer layout determining model in operation A2. The first wafer layout in operation 203 corresponds to the second wafer layout in operation A2.

In a possible implementation, operation 203 includes operations 2031 to 2032 (not shown).

Operation 2031: Determine actual light intensity distribution information based on the predicted mask layout through the first wafer layout determining model, where the actual light intensity distribution information is a light intensity distribution obtained after the predicted mask layout is imaged on a wafer under the conditions of the actual lithography process parameter.

An implementation of operation 2031 is similar to the implementation of operation A21, and may be seen from the descriptions for operation A21. Details are not described herein again. The predicted mask layout in operation 2031 corresponds to the initial mask layout in operation A21. The first wafer layout determining model in operation 2031 corresponds to the second wafer layout determining model in operation A21. The actual light intensity distribution information in operation 2031 corresponds to the reference light intensity distribution information in operation A21.

Since the first wafer layout determining model includes a second lithography process parameter which is an actual lithography process parameter, $h_\mu$ in formula (4) may be any data. For example, a value of $h_\mu$ may be [-80 nm, 0 nm, 80 nm].

Operation 2032: Determine the first wafer layout based on the actual light intensity distribution information through the first wafer layout determining model.

An implementation of operation 2032 is similar to the implementation of operation A22, and may be seen from the descriptions for operation A22. Details are not described herein again. The first wafer layout in operation 2032 corresponds to the second wafer layout in operation A22. The first wafer layout determining model in operation 2032 corresponds to the second wafer layout determining model in operation A22. The actual light intensity distribution information in operation 2032 corresponds to the reference light intensity distribution information in operation A22.

Since the first wafer layout determining model includes a second lithography process parameter which is an actual lithography process parameter, $h_\mu$ in formula (5) may be any data, and $t_q$ may be any data. For example, a value of $h_\mu$ may be [-80 nm, 0 nm, 80 nm], and a value of $t_q$ may be [-0.1, 0.0, 0.1].

Operation 204: Train the neural network model through the labeled mask layout, the predicted mask layout, the sample chip layout, and the first wafer layout, to obtain a mask layout determining model.

The mask layout determining model is a trained model for determining a mask layout, and is configured for determining a target mask layout of a target chip layout.

For example, the target loss is determined through the labeled mask layout, the predicted mask layout, the sample chip layout, and the first wafer layout. The neural network model is trained through the target loss, to obtain a trained neural network model. If the trained neural network model satisfies a training ending condition, the trained neural network model is determined as the mask layout determining model. If the trained neural network model does not satisfy the training ending condition, the trained neural network model is used as a neural network model trained next time, and the neural network model is trained next time according to content of operations 202 to 204, until the trained neural network model satisfies the training ending condition and the trained neural network model is determined as the mask layout determining model.

The content that the trained neural network model satisfies the training ending condition is not limited in this embodiment of the present disclosure. For example, the case that the trained neural network model satisfies the training ending condition is: The quantity of trainings corresponding to the trained neural network model reaches a third set quantity, or the target loss corresponding to the trained neural network model is within a second set range, or the target loss corresponding to the trained neural network model converges.

The third set quantity and the second set range are set according to experience, or are flexibly adjusted according to an application requirement. This is not limited in this embodiment of the present disclosure. The third set quantity may be the same as the first set quantity or the second set quantity, or may be different from both the first set quantity and the second set quantity. The second set range may be the same as or different from the first set range.

The predicted mask layout is determined through the neural network model, so that the predicted mask layout is determined based on a deep learning method, a calculation amount of determining the predicted mask layout is reduced, and efficiency of determining the predicted mask layout is improved. Furthermore, the first wafer layout is determined through the first wafer layout determining model, so that the first wafer layout is determined based on the deep learning method, a calculation amount of determining the first wafer layout is reduced, and efficiency of determining the first wafer layout is improved. Since efficiency of determining the predicted mask layout and the first wafer layout is high and efficiency of determining the labeled mask layout is also high, efficiency of training the mask layout determining model can be improved.

In a possible implementation, operation 204 includes operations 2041 to 2045 (not shown).

Operation 2041: Determine a first target sub-loss through third difference information between the labeled mask layout and the predicted mask layout.

For example, the third difference information between the labeled mask layout and the predicted mask layout is calculated. In some embodiments, the third difference information may be obtained by calculation based on a difference between a pixel value of a pixel in the labeled mask layout and a pixel value of a corresponding pixel in the predicted mask layout. For example, a mean square error between the pixel value of the pixel in the labeled mask layout and the pixel value of the corresponding pixel in the predicted mask layout is used as the third difference information.

The first target sub-loss is determined based on the third difference information, to describe an error between the labeled mask layout and the predicted mask layout through the first target sub-loss. In some embodiments, the first target sub-loss is determined according to the following formula (27).

$$ L_{fit} = |Mask_{pred} - Mask|^2 \qquad \text{Formula (27)} $$

where $L_{fit}$ represents the first target sub-loss. $Mask_{pred}$ - Mask represents the third difference information between the labeled mask layout and the predicted mask layout, $Mask_{pred}$ represents the predicted mask layout, and Mask represents the labeled mask layout.

Operation 2042: Determine a second target sub-loss through fourth difference information between the sample chip layout and the first wafer layout. A mode of determining the second target sub-loss is similar to a mode of determining the first reference sub-loss, and may be seen from the descriptions for operation A31. Details are not described herein again. The "first wafer layout" in operation 2042 corresponds to the "second wafer layout" in operation A31. The "fourth difference information" in operation 2042 corresponds to the "first difference information" in operation A31. The "second target sub-loss" in operation 2042 corresponds to the "first reference sub-loss" in operation A31.

Operation 2043: Determine a target loss based on the first target sub-loss and the second target sub-loss.

In an exemplary embodiment, weighted calculation is performed on the first target sub-loss and the second target sub-loss, to obtain a weighted calculation result used as the target loss. Alternatively, the target loss is determined based on the first target sub-loss and the second target sub-loss according to an exemplary implementation shown below.

In an exemplary implementation, operation 2043 includes: obtaining at least one of a third target sub-loss, a fourth target sub-loss, a fifth target sub-loss, a sixth target sub-loss, or a seventh target sub-loss, where the third target sub-loss is determined based on the predicted mask layout, the fourth target sub-loss is determined based on fifth difference information between the sample chip layout and the predicted mask layout, the fifth target sub-loss is determined based on the fourth difference information and the edge modification information, the sixth target sub-loss is determined based on the predicted mask layout and the edge modification information, the seventh target sub-loss being determined based on the fifth difference information and the edge modification information, and the edge modification information is information for modifying the edge of the sample chip layout; and determining the target loss based on the first target sub-loss, and the second target sub-loss, and at least one of the third target sub-loss, the fourth target sub-loss, the fifth target sub-loss, the sixth target sub-loss, or the seventh target sub-loss.

A mode of determining the third target sub-loss to the seventh target sub-loss in operation 2043 is similar to a mode of determining the second reference sub-loss to the sixth reference sub-loss in operation A321. A corresponding relationship between the target sub-loss and the reference sub-loss is:

A mode of determining the third target sub-loss is similar to a mode of determining the second reference sub-loss, and may be seen from the descriptions for the second reference sub-loss in operation A321. Details are not described herein again. The "predicted mask layout" in operation 2043 corresponds to the "initial mask layout" in operation A321. The "third target sub-loss" in operation 2043 corresponds to the "second reference sub-loss" in operation A321.

A mode of determining the fourth target sub-loss is similar to a mode of determining the third reference sub-loss, and may be seen from the descriptions for the third reference sub-loss in operation A321. Details are not described herein again. The "predicted mask layout" in operation 2043 corresponds to the "initial mask layout" in operation A321. The "fifth difference information" in operation 2043 corresponds to the "second difference information" in operation A321. The "fourth target sub-loss" in operation 2043 corresponds to the "third reference sub-loss" in operation A321.

A mode of determining the fifth target sub-loss is similar to a mode of determining the fourth reference sub-loss, and may be seen from the descriptions for the fourth reference sub-loss in operation A321. Details are not described herein again. The "fourth difference information" in operation 2043 corresponds to the "first difference information" in operation A321. The "fifth target sub-loss" in operation 2043 corresponds to the "fourth reference sub-loss" in operation A321.

A mode of determining the sixth target sub-loss is similar to a mode of determining the fifth reference sub-loss, and may be seen from the descriptions for the fifth reference sub-loss in operation A321. Details are not described herein again. The "predicted mask layout" in operation 2043 corresponds to the "initial mask layout" in operation A321. The "sixth target sub-loss" in operation 2043 corresponds to the "fifth reference sub-loss" in operation A321.

A mode of determining the seventh target sub-loss is similar to a mode of determining the sixth reference sub-loss, and may be seen from the descriptions for the sixth reference sub-loss in operation A321. Details are not described herein again. The "fifth difference information" in operation 2043 corresponds to the "second difference information" in operation A321. The "seventh target sub-loss" in operation 2043 corresponds to the "sixth reference sub-loss" in operation A321.

For example, weighted summation is performed on the first target sub-loss, the second target sub-loss, and at least one of the third target sub-loss, the fourth target sub-loss, the fifth target sub-loss, the sixth target sub-loss, and the seventh target sub-loss. The target loss is determined based on a weighted summation result. For any two target sub-losses in the first target sub-loss to the seventh target sub-loss, weights of the two target sub-losses may be the same or may be different.

In some embodiments, the target loss is determined according to the following formula (28).

$$L_{loss} = L_{fit} + \alpha * L_{total} = |Mask_{pred} - Mask|^2 + \alpha * L_{total} \qquad \text{Formula (28)}$$

where $L_{loss}$ represents the target loss. $L_{fit}$ represents the first target sub-loss. $L_{total}$ represents a sum of target sub-losses obtained after weighted summation is performed on the second target sub-loss to the seventh target sub-loss. The sum of the target sub-losses corresponds to the "reference loss" mentioned above. For a mode of determining $L_{total}$, refer to formula (12). Details are not described herein again. $\alpha$ represents a weight of $L_{total}$, and is an adjustable parameter. A larger size of $\alpha$ represents that training of the neural network model pays more attention to the actual lithography process parameter, thus helping to enlarge a process window for generating the mask layout. $Mask_{pred}$ - Mask represents the third difference information, $Mask_{pred}$ represents the predicted mask layout, and Mask represents the labeled mask layout.

Operation 2044: Determine a second gradient of the target loss relative to a model parameter of the neural network model.

The target loss includes the first target sub-loss, the second target sub-loss, and at least one of the third target sub-loss to the seventh target sub-loss. Therefore, the second gradient of the target loss relative to the model parameter of the neural network model includes three parts. The first part is a gradient of the at least one target sub-loss in the third target sub-loss to the seventh target sub-loss relative to the model parameter of the neural network model. The second part is a gradient of the first target sub-loss relative to the model parameter of the neural network model. The third part is a gradient of the second target sub-loss relative to the model parameter of the neural network model.

An example in which the target loss includes the first target sub-loss to the seventh target sub-loss is used. The second gradient of the target loss relative to the model parameter of the neural network model is shown in the following formula (29).

$$\frac{\partial L_{loss}}{\partial w} = \frac{\partial L_{fit}}{\partial w} + \alpha \times \frac{\partial L_{total}}{\partial Mask_{pred}} \times \frac{\partial Mask_{pred}}{\partial w} \qquad \text{Formula (29)}$$

where $\frac{\partial L_{loss}}{\partial w}$ represents the second gradient, $L_{loss}$ represents the target loss, and w represents the model parameter of the neural network model. $\frac{\partial L_{fit}}{\partial w}$ represents the gradient of the first target sub-loss relative to the model parameter of the neural network model, and $L_{fit}$ represents the first target sub-loss. $\frac{\partial L_{total}}{\partial Mask_{pred}}$ represents the gradient of the sum of target sub-losses obtained after weighted summation is performed on the second target sub-loss to the seventh target sub-loss relative to the predicted mask layout, $L_{total}$ represents the sum of the target sub-losses, and $Mask_{pred}$ represents the

predicted mask layout. $\alpha$ represents the weight of $L_{total}$. $\frac{\partial Mask_{pred}}{\partial w}$ represents the gradient of the predicted mask layout relative to the model parameter of the neural network model.

The "model parameter of the neural network model" mentioned in this embodiment of the present disclosure refers to a weight of each neuron included in the neural network model.

Operation 2045: Adjust the model parameter of the neural network model based on the second gradient, to obtain the mask layout determining model.

For example, an adjustment step of the model parameter is determined based on the second gradient, and the model parameter of the neural network model is adjusted based on the second gradient and the adjustment step, to obtain an adjusted model parameter, so that the neural network model is trained once, to obtain a trained neural network model. The model parameter of the trained neural network model is the adjusted model parameter.

If the trained neural network model satisfies a training ending condition, the trained neural network model is determined as the mask layout determining model. If the trained neural network model does not satisfy the training ending condition, the trained neural network model is trained next time, until the trained neural network model satisfies the training ending condition and the trained neural network model is determined as the mask layout determining model. Content of the training ending condition is described above. Details are not described herein again.

In this embodiment of the present disclosure, the second gradient of the target loss relative to the model parameter of the neural network model is calculated, to minimize the target loss through a gradient descent method. The target loss includes the first target sub-loss, the second target sub-loss, and at least one of the third target sub-loss to the seventh target sub-loss. By minimizing the target loss, the first target sub-loss, the second target sub-loss, and the at least one of the third target sub-loss to the seventh target sub-loss may be minimized.

The first target sub-loss is determined based on the third difference information between the labeled mask layout and the predicted mask layout. By minimizing the first target sub-loss, the predicted mask layout outputted by the model increasingly approaches the labeled mask layout, so that a target mask layout with high accuracy can be determined through the mask layout determining model.

The second target sub-loss is determined based on the fourth difference information between the sample chip layout and the first wafer layout. By minimizing the second target sub-loss, under the conditions of the actual lithography process parameter, a wafer layout similar to the sample chip layout can be obtained based on the mask layout outputted by the model, thus helping to improve the quality of the wafer layout, so that the target mask layout determined through the mask layout determining model has high quality.

The third target sub-loss is determined based on the predicted mask layout. The third target sub-loss may reflect an error between continuous distribution of the predicted mask layout and discrete distribution of a binary mask layout. By minimizing the third target sub-loss, the predicted mask layout may increasingly approach the binary mask layout, thereby improving the accuracy of the predicted mask layout.

The fourth target sub-loss is determined based on the fifth difference information between the sample chip layout and the predicted mask layout. The fourth target sub-loss may measure complexity of the predicted mask layout. By minimizing the fourth target sub-loss, the complexity of the predicted mask layout can be reduced, the manufacturability of the predicted mask layout can be improved, and a process window for generating the mask layout can be enlarged.

The fifth target sub-loss is determined based on the fourth difference information between the sample chip layout and the first wafer layout and the edge modification information. The fifth target sub-loss may describe an error between the sample chip layout and the first wafer layout in a case that noise exists in the sample chip layout. By minimizing the fifth target sub-loss, a generalization capability of the model is improved, so that the model can output a high-quality mask layout. In short, even if there is a small difference between two chip layouts, the model can output a mask layout of each chip layout, and a wafer layout highly similar to the chip layout can be obtained based on the mask layout of any chip layout, so that there can also be a difference between the two chip layouts.

The sixth target sub-loss is determined based on the edge modification information and the predicted mask layout. The sixth target sub-loss may reflect the error between the continuous distribution of the predicted mask layout and the discrete distribution of the binary mask layout in a case that the predicted mask layout has the same noise as that of the sample chip layout. By minimizing the sixth target sub-loss, the generalization capability of the model can be improved, so that the model can output an accurate mask layout. In short, even if there is a small difference between two chip layouts, the model can output a mask layout of each chip layout, and the two mask layouts have a difference between the two chip layouts. Any mask layout is similar to the binary mask layout, and the mask layout has high accuracy.

The seventh target sub-loss is determined based on the fifth difference information between the sample chip layout and the predicted mask layout and the edge modification information. The seventh target sub-loss may measure the complexity of the predicted mask layout in a case that the predicted mask layout has the same noise as that of the sample chip layout. By minimizing the seventh target sub-loss, the generalization capability of the model can be improved, so that the model can output a mask layout with low complexity. In short, even if there is a small difference between two chip layouts, the model can output a mask layout of each chip layout. The two mask layouts can have a difference between the two chip layouts, and any mask layout has low complexity.

The target loss includes the first target sub-loss, the second target sub-loss, and at least one of the third target sub-loss to the seventh target sub-loss. Therefore, the mask layout determining model has effects corresponding to the first target sub-loss, the second target sub-loss, and the at least one of the third target sub-loss to the seventh target sub-loss. Furthermore, the target loss may further include another target sub-loss.

For example, this target sub-loss is an eighth target sub-loss. In some embodiments, a first wafer layout of the predicted mask layout is determined through at least two first wafer layout determining models, where any two first wafer layout determining models include different actual lithography process parameters. The eighth target sub-loss is determined based on sixth difference information between every two first wafer layouts. A target loss is determined based on the eighth target sub-loss, the first target sub-loss, the second target sub-loss, and at least one of the third target sub-loss to the seventh target sub-loss. The neural network model is trained through the target loss, to obtain the mask layout determining model. The eighth target sub-loss is configured for measuring an error between the first wafer layouts generated by the predicted mask layout under the conditions of different actual lithography process parameters, so that the complexity of the predicted mask layout can be measured.

Usually, the complexity of the mask layout is positively correlated to a manufacturing cost of the mask layout. This is because the mask layout with high complexity has more tiny structures. These tiny structures include, but are not limited to, holes, extensions, and aliasing. A larger quantity of tiny structures indicates a higher manufacturing cost of the mask layout. By minimizing the target loss, the eighth target sub-loss may be minimized, so that the first wafer layouts generated by the predicted mask layout under the conditions of different actual lithography process parameters are increasingly similar to each other, thereby reducing the complexity of the predicted mask layout, and reducing the manufacturing cost of the predicted mask layout.

A ninth target sub-loss may further be determined based on the sixth difference information and the edge modification information. A target loss is determined based on the first target sub-loss, the second target sub-loss, and at least one of the third target sub-loss to the ninth target sub-loss. The neural network model is trained through the target loss, to obtain the mask layout determining model. By minimizing the target loss, the ninth target sub-loss may be minimized. While the generalization capability of the model is improved, the model can output a mask layout with low complexity.

Furthermore, a second wafer layout of the initial mask layout may be determined through at least two second wafer layout determining models according to a principle of determining the eighth target sub-loss, where any two second wafer layout determining models include different reference lithography process parameters. The seventh reference sub-loss is determined based on seventh difference information between every two second wafer layouts. The eighth reference sub-loss may further be determined based on the seventh difference information and the edge modification information according to a principle of determining the ninth target sub-loss.

A reference loss is determined based on the first reference sub-loss and at least one of the second reference sub-loss to the eighth reference sub-loss. The initial mask layout is adjusted through the reference loss, to obtain the labeled mask layout. The seventh reference sub-loss is configured for measuring an error between the second wafer layouts generated by the initial mask layout under the conditions of different reference lithography process parameters, so that the complexity of the initial mask layout can be measured. The eighth reference sub-loss may measure the complexity of the initial mask layout in a case that the initial mask layout has the same noise as that of the sample chip layout. By reducing the reference loss, the complexity of the labeled mask layout can be reduced.

The information (including, but not limited to, user equipment information, user personal information, and the like), data (including, but not limited to, data for analysis, stored data, displayed data, and the like), and signals involved in the present disclosure all are authorized by the user or fully authorized by each party, and the collection, use, and processing of relevant data need to comply with relevant laws and regulations of relevant regions. For example, the sample chip layout, the reference lithography process parameter, the actual lithography process parameter, and the like involved in the present disclosure are all obtained under full authorization.

By using the foregoing method, a predicted mask layout of a sample chip layout is determined through a neural network model, and a first wafer layout in which an actual lithography process parameter is considered is determined based on the predicted mask layout. The neural network model is trained through a labeled mask layout, the predicted mask layout, the sample chip layout, and the first wafer layout, to obtain a mask layout determining model, so that a target mask layout determined through the mask layout determining model better conforms to the actual lithography process parameter, and a wafer layout highly similar to a target chip layout can be obtained under the conditions of the actual lithography process parameter, thereby improving the quality of the target mask layout.

Furthermore, the initial mask layout is optimized step by step through the second wafer layout determining model, to obtain the labeled mask layout, so that the labeled mask layout is determined based on a deep learning method, a calculation amount of determining the labeled mask layout is reduced, and efficiency of determining the labeled mask layout is improved. The initial mask layout is constantly adjusted through the sample chip layout and the second wafer layout, so that the mask layout is constantly optimized toward a direction in which the wafer layout can increasingly approach the sample chip layout, thereby achieving high accuracy of the labeled mask layout.

By modifying the edge of the sample chip layout, noise is introduced into the sample chip layout, and the complexity of the sample chip layout is reduced, so that the mask layout and the wafer layout can more easily approach the sample chip layout, thereby helping to improve generalization capability and accuracy of the mask layout determining model.

The predicted mask layout is determined through the neural network model, so that the predicted mask layout is determined based on a deep learning method, a calculation amount of determining the predicted mask layout is reduced, and efficiency of determining the predicted mask layout is improved. Furthermore, the first wafer layout is determined through the first wafer layout determining model, so that the first wafer layout is determined based on the deep learning method, a calculation amount of determining the first wafer layout is reduced, and efficiency of determining the first wafer layout is improved. Since efficiency of determining the predicted mask layout and the first wafer layout is high and efficiency of determining the labeled mask layout is also high, efficiency of training the mask layout determining model can be improved.

This embodiment of the present disclosure provides a method for determining a mask layout. The method may be applied to the foregoing implementation environment. A high-quality mask layout may be determined, so that a wafer layout determined based on the mask layout is highly similar to a chip layout. A flowchart of a method for determining a mask layout according to an embodiment of the present disclosure shown in FIG. 5 is used as an example. For ease of description, the terminal device 101 or the server 102 that performs the method for determining a mask layout in this embodiment of the present disclosure is referred to as an electronic device. The method may be performed by the electronic device. As shown in FIG. 5, the method includes the following operations 501 and 502.

Operation 501: Obtain a target chip layout. Content of the target chip layout is similar to content of the sample chip layout, and may be seen from the descriptions for operation 201. Details are not described herein again.

Operation 502: Determine a target mask layout of the target chip layout through a mask layout determining model. The mask layout determining model is obtained by training according to the method for training a mask layout determining model related to FIG. 2, and the target mask layout is a mask layout of the target chip layout obtained by prediction.

A mode of determining the target mask layout is similar to a mode of determining the predicted mask layout, and may be seen from the descriptions for operation 202. Details are not described herein again. The "mask layout determining model" in operation 502 corresponds to the "neural network model" in operation 202. The "target chip layout" in operation 502 corresponds to the "sample chip layout" in operation 202. The "target mask layout" in operation 502 corresponds to the "predicted mask layout" in operation 202.

In a possible implementation, operation 502 includes: encoding the target chip layout through the mask layout determining model, to obtain a layout feature of the target chip layout; and decoding the layout feature of the target chip layout through the mask layout determining model, to obtain the target mask layout.

A mode of encoding the target chip layout is similar to the manner of encoding the sample chip layout, and may be seen from the descriptions for operation 2021. A mode of decoding the layout feature of the target chip layout is similar to a mode of decoding the layout feature of the sample chip layout, and may be seen from the descriptions for operation 2022. Details are not described herein again.

In this embodiment of the present disclosure, the target chip layout is inputted to the mask layout determining model, and the target mask layout of the target chip layout is determined through the mask layout determining model, so that the target mask layout is determined based on a deep learning method, a calculation amount of determining the target mask layout is reduced, and efficiency of determining the target mask layout is improved.

The information (including, but not limited to, user equipment information, user personal information, and the like), data (including, but not limited to, data for analysis, stored data, displayed data, and the like), and signals involved in the present disclosure all are authorized by the user or fully authorized by each party, and the collection, use, and processing of relevant data need to comply with relevant laws and regulations of relevant regions. For example, the target chip layout and the like involved in the present disclosure are obtained under full authorization.

The mask layout determining model in the foregoing method is obtained by training in the following mode: determining a predicted mask layout of a sample chip layout through a neural network model, and determining, based on the predicted mask layout, a first wafer layout in which an actual lithography process parameter is considered; and training the neural network model through a labeled mask layout, the predicted mask layout, the sample chip layout, and the first wafer layout, to obtain a mask layout determining model. Since the actual lithography process parameter is considered in the training process of the mask layout determining model, a target mask layout determined through the mask layout determining model better conforms to the actual lithography process parameter, and a wafer layout highly similar to a target chip layout can be obtained under the conditions of the actual lithography process parameter, thereby improving the quality of the target mask layout.

The foregoing describes the method for training a mask layout determining model and the method for determining a mask layout in this embodiment of the present disclosure from the perspective of method operations. The following describes the methods systematically and comprehensively.

In this embodiment of the present disclosure, two lithography mask data sets may be obtained. There are approximately 10271 chip layouts and corresponding mask layouts in the two lithography mask data sets, and these chip layouts satisfy a 32nm lithography process and a certain design rule. Furthermore, a chip layout of a contact hole (VIA) type and a corresponding mask layout may further be obtained. The foregoing mask layout is obtained by optimizing the chip layout according to an inverse lithography mask optimization algorithm in an inverse lithography technology and by using the wafer layout determining model (i.e. the second wafer layout determining model mentioned above) including the reference lithography process parameter. For this, refer to content of operations A1 to A3. Details are not described herein again. Any chip layout may be used as the sample chip layout, and the mask layout corresponding to the sample chip layout is the labeled mask layout.

The initial network model is trained to be the mask layout determining model based on the sample chip layout and the labeled mask layout. This training process is roughly divided into two stages. The first stage is: pre-training the initial network model based on the sample chip layout and the labeled mask layout, to obtain the neural network model. The second stage is: optimally training the neural network model based on the sample chip layout and the labeled mask layout, to obtain the mask layout determining model. The two stages are separately described below.

First, the first stage is performed. Refer to FIG. 6. FIG. 6 is a schematic diagram of pre-training an initial network model according to an embodiment of the present disclosure. In the pre-training stage, a sample chip layout may be inputted to the initial network model, and a predicted mask layout is outputted through the initial network model. A loss of the initial network model is determined based on difference information between the predicted mask layout and a labeled mask layout. A model parameter of the initial network model is adjusted based on the loss of the initial network model, to obtain an adjusted initial network model. In this way, the initial network model is trained once based on the sample chip layout and the labeled mask layout.

If the quantity of trainings reaches a second set quantity, the adjusted initial network model is used as a neural network model. If the quantity of trainings does not reach the second set quantity, the adjusted initial network model is used as the initial network model, and the initial network model is trained next time based on the sample chip layout and the labeled mask layout according to the foregoing content, until the quantity of trainings reaches the second set quantity and the adjusted initial network model is used as the neural network model.

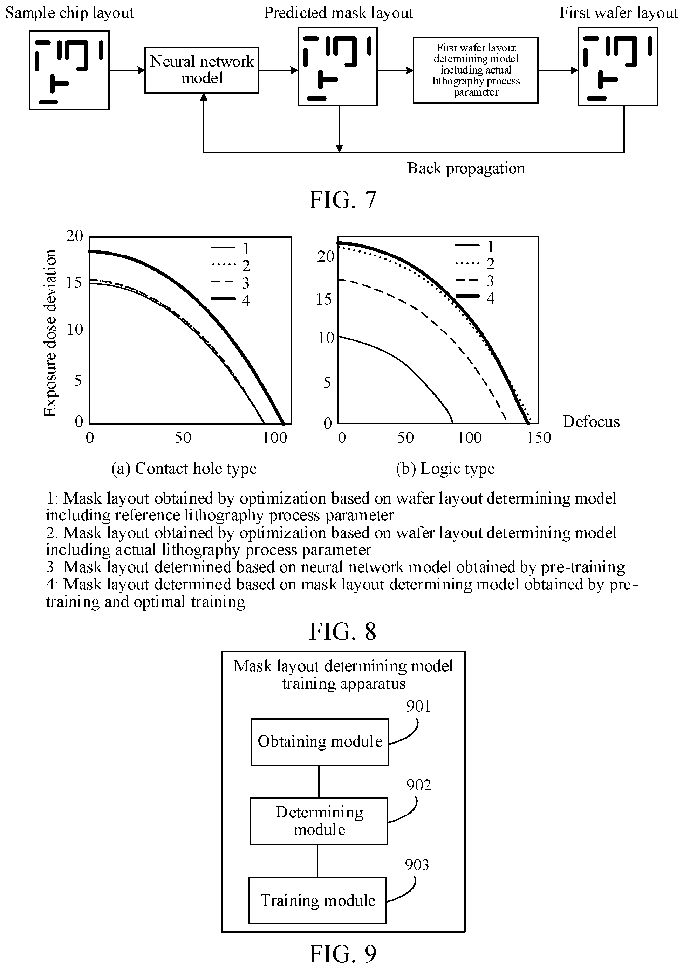

The second stage is performed after the neural network model is obtained by training. Refer to FIG. 7. FIG. 7 is a schematic diagram of optimally training a neural network model according to an embodiment of the present disclosure. In the optimal training stage, a sample chip layout may be inputted to the neural network model, and a predicted mask layout is outputted through the neural network model. The predicted mask layout is inputted to a first wafer layout determining model including an actual lithography process parameter, to obtain a first wafer layout. A loss (i.e. the target loss mentioned above) of the neural network model is determined based on the sample chip layout, the first wafer layout, the predicted mask layout, and a labeled mask layout. A model parameter of the neural network model is adjusted based on the loss of the neural network model, to obtain an adjusted neural network model. In this way, the neural network model is trained once based on the sample chip layout and the labeled mask layout.

If the quantity of trainings reaches a third set quantity, the adjusted neural network model is used as a mask layout determining model. If the quantity of trainings does not reach the third set quantity, the adjusted neural network model is used as the neural network model, and the neural network model is trained next time based on the sample chip layout and the labeled mask layout according to the foregoing content, until the quantity of trainings reaches the third set quantity and the adjusted neural network model is used as the mask layout determining model.

After the mask layout determining model is obtained by training, a target chip layout may be inputted to the mask layout determining model, and a target mask layout is outputted through the mask layout determining model. Since the actual lithography process parameter is considered in an optimization training stage, a process window of the target mask layout is large. Refer to FIG. 8. FIG. 8 is a schematic diagram of a mask process window according to an embodiment of the present disclosure. The mask process window includes an exposure dose deviation range and a defocus range.

For a chip layout of a contact hole type and a chip layout of a logic type, corresponding mask layouts may be obtained in modes 1 to 4. Mode 1 is: obtaining a mask layout by optimization based on a wafer layout determining model including a reference lithography process parameter. The mask layout is the labeled mask layout mentioned above. Mode 2 is: obtaining a mask layout by optimization based on a wafer layout determining model including an actual lithography process parameter. The mode of determining the mask layout is similar to the mode of determining the labeled mask layout. Details are not described herein again. Mode 3 is: determining a mask layout based on a neural network model obtained by pre-training. The mask layout is a predicted mask layout outputted by the neural network model. Mode 4 is: determining a mask layout based on a mask layout determining model obtained by pre-training and optimal training. The mask layout is the target mask layout mentioned above.

For the mask layouts corresponding to the chip layouts of the contact hole type that are obtained by using modes 1 to 4, statistics about relationships between two process parameters, i.e. an exposure dose deviation and defocus, of various mask layouts may be collected, to obtain (a) in FIG. 8. For the mask layouts corresponding to the chip layouts of the logic hole type that are obtained by using modes 1 to 4, statistics about relationships between two process parameters, i.e. an exposure dose deviation and defocus, of various mask layouts may be collected, to obtain (b) in FIG. 8.

It can be seen from (a) in FIG. 8 and (b) in FIG. 8 that, in a case of the same defocus, the target mask layout corresponds to a larger exposure dose deviation, and in a case of the same exposure dose deviation, the target mask layout corresponds to a larger defocus. Therefore, the mask layout determining model in this embodiment of the present disclosure may determine a mask layout with a larger process window.

FIG. 9 is a schematic structural diagram of a device for training a mask layout determining model according to an embodiment of the present disclosure. As shown in FIG. 9, the device includes:

an obtaining module 901, configured to obtain a labeled mask layout and a sample chip layout, where the labeled mask layout is a mask layout of the sample chip layout determined under conditions of a first lithography process parameter which is a reference lithography process parameter;

a determining module 902, configured to determine a predicted mask layout of the sample chip layout through a neural network model, where the predicted mask layout is a mask layout of the sample chip layout obtained by prediction;

the determining module 902, further configured to determine a first wafer layout of the predicted mask layout through a first wafer layout determining model, where the first wafer layout determining model includes a second lithography process parameter which is an actual lithography process parameter, and the first wafer layout is a wafer layout of the predicted mask layout obtained by prediction; and

a training module 903, configured to train the neural network model through the labeled mask layout, the predicted mask layout, the sample chip layout, and the first wafer layout, to obtain a mask layout determining model, where the mask layout determining model is configured for determining a target mask layout of a target chip layout.

In a possible implementation, the obtaining module 901 is configured to: generate an initial mask layout based on the sample chip layout; determine a second wafer layout of the initial mask layout through a second wafer layout determining model, where the second wafer layout determining model includes the reference lithography process parameter, and the second wafer layout is a wafer layout of the initial mask layout obtained by prediction; and adjust the initial mask layout based on the sample chip layout and the second wafer layout, to obtain the labeled mask layout.

In a possible implementation, the obtaining module 901 is configured to: determine reference light intensity distribution information based on the initial mask layout through the second wafer layout determining model, where the reference light intensity distribution information is a light intensity distribution obtained after the initial mask layout is imaged on a wafer under the conditions of the reference lithography process parameter; and determine the second wafer layout based on the reference light intensity distribution information through the second wafer layout determining model.

In a possible implementation, the second wafer layout determining model includes multiple kernel functions. The obtaining module 901 is configured to: activate the initial mask layout, to obtain a reference mask layout; and convolve the reference mask layout with the kernel functions, to obtain the reference light intensity distribution information based on convolution processing results.

In a possible implementation, the second wafer layout determining model includes an activation function. The obtaining module 901 is configured to activate the reference light intensity distribution information through the activation function, to obtain the second wafer layout.

In a possible implementation, the obtaining module 901 is configured to: determine a first reference sub-loss based on first difference information between the sample chip layout and the second wafer layout; determine a reference loss based on the first reference sub-loss; determine a first gradient of the reference loss relative to the initial mask layout; and adjust the initial mask layout based on the first gradient, to obtain the labeled mask layout.

In a possible implementation, the obtaining module 901 is configured to: obtain at least one of a second reference sub-loss, a third reference sub-loss, a fourth reference sub-loss, a fifth reference sub-loss, or a sixth reference sub-loss, where the second reference sub-loss is determined based on the initial mask layout, the third reference sub-loss is determined based on second difference information between the sample chip layout and the initial mask layout, the fourth reference sub-loss is determined based on the first difference information and edge modification information, the fifth reference sub-loss is determined based on the initial mask layout and the edge modification information, the sixth reference sub-loss is determined based on the second difference information and the edge modification information, and the edge modification information is information for modifying an edge of the sample chip layout; and determine the reference loss based on the first reference sub-loss and at least one of the second reference sub-loss, the third reference sub-loss, the fourth reference sub-loss, the fifth reference sub-loss, or the sixth reference sub-loss.

In a possible implementation, the obtaining module 901 is further configured to modify the edge of the sample chip layout according to an edge modification distance and an edge modification amplitude, to obtain the edge modification information.

In a possible implementation, the obtaining module 901 is configured to: determine an adjustment step based on the first gradient; adjust the initial mask layout based on the adjustment step and the first gradient, to obtain an adjusted mask layout; and activate the adjusted mask layout in a case that the adjusted mask layout satisfies an adjustment ending condition, to obtain the labeled mask layout.

In a possible implementation, the obtaining module 901 is further configured to: determine a third wafer layout of the adjusted mask layout through the second wafer layout determining model in a case that the adjusted mask layout does not satisfy the adjustment ending condition, where the third wafer layout is a wafer layout of the adjusted mask layout obtained by prediction under the conditions of the reference lithography process parameter; and adjust the adjusted mask layout based on the sample chip layout and the third wafer layout, to obtain the labeled mask layout.

In a possible implementation, the sample chip layout includes at least one geometrical pattern. The obtaining module 901 is configured to: use a sum of perimeters of the geometrical patterns as an edge length of the sample chip layout; and determine the first reference sub-loss based on the first difference information and the edge length of the sample chip layout.

In a possible implementation, the determining module 902 is configured to: encode the sample chip layout through the neural network model, to obtain a layout feature of the sample chip layout; and decode the layout feature of the sample chip layout through the neural network model, to obtain the predicted mask layout.

In a possible implementation, the determining module 902 is configured to: determine actual light intensity distribution information based on the predicted mask layout through the first wafer layout determining model, where the actual light intensity distribution information is a light intensity distribution obtained after the predicted mask layout is imaged on a wafer under the conditions of the actual lithography process parameter; and determine the first wafer layout based on the actual light intensity distribution information through the first wafer layout determining model.

In a possible implementation, the training module 903 is configured to: determine a first target sub-loss through third difference information between the labeled mask layout and the predicted mask layout; determine a second target sub-loss through fourth difference information between the sample chip layout and the first wafer layout; determine a target loss based on the first target sub-loss and the second target sub-loss; determine a second gradient of the target loss relative to a model parameter of the neural network model; and adjust the model parameter of the neural network model based on the second gradient, to obtain the mask layout determining model.

In a possible implementation, the training module 903 is configured to: obtain at least one of a third target sub-loss, a fourth target sub-loss, a fifth target sub-loss, a sixth target sub-loss, or a seventh target sub-loss, where the third target sub-loss is determined based on the predicted mask layout, the fourth target sub-loss is determined based on fifth difference information between the sample chip layout and the predicted mask layout, the fifth target sub-loss is determined based on the fourth difference information and the edge modification information, the sixth target sub-loss is determined based on the predicted mask layout and the edge modification information, the seventh target sub-loss being determined based on the fifth difference information and the edge modification information, and the edge modification information is information for modifying the edge of the sample chip layout; and determine the target loss based on the first target sub-loss, and the second target sub-loss, and at least one of the third target sub-loss, the fourth target sub-loss, the fifth target sub-loss, the sixth target sub-loss, or the seventh target sub-loss.

The foregoing device determines a predicted mask layout of a sample chip layout through a neural network model, and determines, based on the predicted mask layout, a first wafer layout in which an actual lithography process parameter is considered. The neural network model is trained through a labeled mask layout, the predicted mask layout, the sample chip layout, and the first wafer layout, to obtain a mask layout determining model, so that a target mask layout determined through the mask layout determining model better conforms to the actual lithography process parameter, and a wafer layout highly similar to a target chip layout can be obtained under the conditions of the actual lithography process parameter, thereby improving the quality of the target mask layout.

When the device provided in FIG. 9 implements the functions of the device, only division into the foregoing function modules is used as an example for description. In the practical application, the functions may be allocated to and completed by different function modules according to requirements. To be specific, an internal structure of the device is divided into different function modules, to complete all or some of the functions described above. In addition, the device provided in the foregoing embodiments and the method embodiments shown in FIG. 2 belong to the same concept. For details of a specific implementation process, refer to the method embodiments shown in FIG. 2. Details are not described herein again.

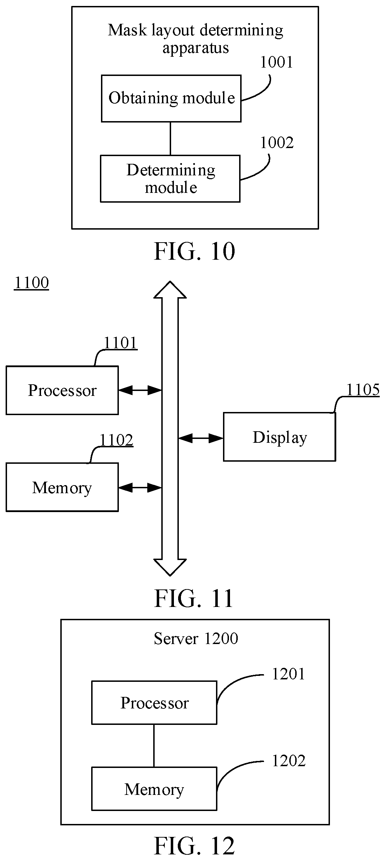

FIG. 10 is a schematic structural diagram of a device for determining a mask layout according to an embodiment of the present disclosure. As shown in FIG. 10, the device includes:

an obtaining module 1001, configured to obtain a target chip layout; and

a determining module 1002, configured to determine a target mask layout of the target chip layout through a mask layout determining model, where the mask layout determining model is obtained by training through the method for training a mask layout determining model according to any content in the first aspect, and the target mask layout is a mask layout of the target chip layout obtained by prediction.

In a possible implementation, the determining module 1002 is configured to: encode the target chip layout through the mask layout determining model, to obtain a layout feature of the target chip layout; and decode the layout feature of the target chip layout through the mask layout determining model, to obtain the target mask layout.

The mask layout determining model in the foregoing device is obtained by training in the following mode: determining a predicted mask layout of a sample chip layout through a neural network model, and determining, based on the predicted mask layout, a first wafer layout in which an actual lithography process parameter is considered; and training the neural network model through a labeled mask layout, the predicted mask layout, the sample chip layout, and the first wafer layout, to obtain a mask layout determining model. Since the actual lithography process parameter is considered in the training process of the mask layout determining model, a target mask layout determined through the mask layout determining model better conforms to the actual lithography process parameter, and a wafer layout highly similar to a target chip layout can be obtained under the conditions of the actual lithography process parameter, thereby improving the quality of the target mask layout.

When the device provided in FIG. 10 implements the functions of the device, only division into the foregoing function modules is used as an example for description. In the practical application, the functions may be allocated to and completed by different function modules according to requirements. To be specific, an internal structure of the device is divided into different function modules, to complete all or some of the functions described above. In addition, the device provided in the foregoing embodiments and the method embodiments shown in FIG. 5 belong to the same concept. For details of a specific implementation process, refer to the method embodiments shown in FIG. 5. Details are not described herein again.

FIG. 11 shows a structural block diagram of a terminal device 1100 according to an exemplary embodiment of the present disclosure. The terminal device 1100 includes: a processor 1101 and a memory 1102.

The processor 1101 may include one or more processing cores, for example, a 4-core processor or an 8-core processor. The processor 1101 may be implemented in at least one hardware form of a digital signal processor (DSP), a field-programmable gate array (FPGA), and a programmable logic array (PLA). The processor 1101 may alternatively include a main processor and a coprocessor. The main processor is configured to process data in a wake-up state, also referred to as a central processing unit (CPU). The coprocessor is a low-power-consumption processor configured to process data in a standby state. In some embodiments, the processor 1101 may be integrated with a graphics processing unit (GPU). The GPU is configured to render and draw content that needs to be displayed on a display. In some embodiments, the processor 1101 may further include an AI processor. The AI processor is configured to process computing operations related to machine learning.

The memory 1102 may include one or more computer-readable storage media. The computer-readable storage medium may be non-transient. The memory 1102 may further include a high-speed random access memory and a nonvolatile memory, for example, one or more disk storage devices or flash storage devices. In some embodiments, the non-transient computer-readable storage medium in the memory 1102 is configured to store at least one computer program. The at least one computer program is configured for being executed by the processor 1101, to cause the terminal device 1100 to implement the method for training a mask layout determining model or the method for determining a mask layout provided in the method embodiments of the present disclosure.

In some embodiments, the terminal device 1100 may alternatively include: a display 1105.

The display 1105 is configured to display a user interface (UI). The UI may include a graph, text, an icon, a video, and any combination thereof. When the display 1105 is a touch display, the display 1105 further has a capability of acquiring a touch signal on or above a surface of the display 1105. The touch signal may be inputted to the processor 1101 as a control signal for processing. In this case, the display 1105 may be further configured to provide a virtual button and/or a virtual keyboard that are/is also referred to as a soft button and/or a soft keyboard. In some embodiments, one display 1105 may be disposed on a front panel of the terminal device 1100. In some other embodiments, at least two displays 1105 may be separately disposed on different surfaces of the terminal device 1100 or in a folded design. In some other embodiments, the display 1105 may be a flexible display disposed on a curved surface or a folded surface of the terminal device 1100. Even, the display 1105 may be further set in a non-rectangular irregular pattern. To be specific, the display is a special-shaped display. The display 1105 may be prepared by using materials such as a liquid crystal display (LCD) or an organic light-emitting diode (OLED). For example, a chip layout, a mask layout, a wafer layout, and the like may be displayed by using the display 1105.

The structure shown in FIG. 11 constitutes no limitation on the terminal device 1100, and the terminal device may include more or fewer components than those shown in the figure, or some components may be combined, or a different component deployment may be used.

FIG. 12 is a schematic structural diagram of a server according to an embodiment of the present disclosure. The server 1200 may vary greatly due to different configurations or performance, and may include one or more processors 1201 and one or more memories 1202. The one or more memories 1202 have at least one computer program stored therein. The at least one computer program is loaded and executed by the one or more processors 1201, to cause the server 1200 to implement the method for training a mask layout determining model or the method for determining a mask layout provided in the foregoing method embodiments. For example, the processor 1201 is a CPU. It is clear that the server 1200 may further have components such as a wired or wireless network interface, a keyboard, an input/output interface for input and output. The server 1200 may further include other components configured to implement device functions. Details are not described herein again.

In an exemplary embodiment, a non-volatile computer-readable storage medium is further provided. The non-volatile computer-readable storage medium has at least one computer program stored therein. The at least one computer program is loaded and executed by a processor, to cause an electronic device to implement the method for training a mask layout determining model or the method for determining a mask layout according to any one of the foregoing aspects.

In some embodiments, the non-volatile computer-readable storage medium may be a read-only memory (ROM), a random access memory (RAM), a compact disc read-only memory (CD-ROM), a magnetic tape, a floppy disk, an optical data storage device, or the like.

In an exemplary embodiment, a computer program or a computer program product is further provided. The computer program or the computer program product has at least one computer program stored therein. The at least one computer program is loaded and executed by a processor, to cause an electronic device to implement the method for training a mask layout determining model or the method for determining a mask layout according to any one of the foregoing aspects.

"Multiple" mentioned in the specification means two or more. "And/or" describes an association relationship for describing associated objects and represents that three relationships may exist. For example, A and/or B may represent the following three cases: Only A exists, both A and B exist, and only B exists. The character "/" generally indicates an "or" relationship between the associated objects.

The foregoing descriptions are merely exemplary embodiments of the present disclosure, but are not intended to limit the present disclosure. Any modification, equivalent replacement, or improvement made within the principle of the present disclosure shall fall within the protection scope of the present disclosure.

**Claims**

1. A method for training a model for determining a mask layout, executable by an electronic device, the method comprising:

    obtaining a labeled mask layout and a sample chip layout, the labeled mask layout corresponding to the sample chip layout and being based on a first lithography process parameter;
    determining a predicted mask layout of the sample chip layout through a neural network model;
    determining a first wafer layout of the predicted mask layout through a first wafer layout determining model, the first wafer layout determining model comprising a second lithography process parameter; and
    training the neural network model through the labeled mask layout, the predicted mask layout, the sample chip layout, and the first wafer layout, to obtain a model for determining a mask layout.

2. The method according to claim 1, wherein the obtaining a labeled mask layout comprises:

   generating an initial mask layout based on the sample chip layout;
   determining a second wafer layout of the initial mask layout through a second wafer layout determining model, the second wafer layout determining model comprising the first lithography process parameter; and
   adjusting the initial mask layout based on the sample chip layout and the second wafer layout, to obtain the labeled mask layout.

3. The method according to claim 2, wherein the determining a second wafer layout of the initial mask layout through a second wafer layout determining model comprises:

   determining reference light intensity distribution information based on the initial mask layout through the second wafer layout determining model, the reference light intensity distribution information being a light intensity distribution obtained after the initial mask layout is imaged on a wafer under the conditions of the first lithography process parameter; and
   determining the second wafer layout based on the reference light intensity distribution information through the second wafer layout determining model.

4. The method according to claim 3, wherein the second wafer layout determining model comprises multiple kernel functions, and the determining reference light intensity distribution information based on the initial mask layout through the second wafer layout determining model comprises:

   activating the initial mask layout, to obtain a reference mask layout; and
   convolving the reference mask layout with the kernel functions, to obtain the reference light intensity distribution information based on convolution processing results.

5. The method according to claim 3 or 4, wherein the second wafer layout determining model comprises an activation function, and the determining the second wafer layout based on the reference light intensity distribution information through the second wafer layout determining model comprises:
   activating the reference light intensity distribution information through the activation function, to obtain the second wafer layout.

6. The method according to any one of claims 2 to 5, wherein the adjusting the initial mask layout based on the sample chip layout and the second wafer layout, to obtain the labeled mask layout comprises:

   determining a first reference sub-loss based on first difference information between the sample chip layout and the second wafer layout;
   determining a reference loss based on the first reference sub-loss;
   determining a first gradient of the reference loss relative to the initial mask layout; and
   adjusting the initial mask layout based on the first gradient, to obtain the labeled mask layout.

7. The method according to claim 6, wherein the determining a reference loss based on the first reference sub-loss comprises:

   obtaining at least one of a second reference sub-loss, a third reference sub-loss, a fourth reference sub-loss, a fifth reference sub-loss, or a sixth reference sub-loss, the second reference sub-loss being determined based on the initial mask layout, the third reference sub-loss being determined based on second difference information between the sample chip layout and the initial mask layout, the fourth reference sub-loss being determined based on the first difference information and edge modification information, the fifth reference sub-loss being determined based on the initial mask layout and the edge modification information, the sixth reference sub-loss being determined based on the second difference information and the edge modification information, and the edge modification information being information for modifying an edge of the sample chip layout; and
   determining the reference loss based on the first reference sub-loss and at least one of the second reference sub-loss, the third reference sub-loss, the fourth reference sub-loss, the fifth reference sub-loss, or the sixth reference sub-loss.

8. The method according to claim 7, further comprising:
   modifying the edge of the sample chip layout according to an edge modification distance and an edge modification amplitude, to obtain the edge modification information.

9. The method according to any one of claims 6 to 8, wherein the adjusting the initial mask layout based on the first gradient, to obtain the labeled mask layout comprises:

determining an adjustment step based on the first gradient;
adjusting the initial mask layout based on the adjustment step and the first gradient, to obtain an adjusted mask layout; and
activating the adjusted mask layout in a case that the adjusted mask layout satisfies an adjustment ending condition, to obtain the labeled mask layout.

10. The method according to claim 9, after the adjusting the initial mask layout based on the adjustment step and the first gradient, to obtain an adjusted mask layout, the method further comprises:

determining a third wafer layout of the adjusted mask layout through the second wafer layout determining model in a case that the adjusted mask layout does not satisfy the adjustment ending condition; and
adjusting the adjusted mask layout based on the sample chip layout and the third wafer layout, to obtain the labeled mask layout.

11. The method according to any one of claims 6 to 10, wherein the sample chip layout comprises at least one geometrical pattern, and the determining a first reference sub-loss based on first difference information between the sample chip layout and the second wafer layout comprises:

using a sum of perimeters of the geometrical patterns as an edge length of the sample chip layout; and
determining the first reference sub-loss based on the first difference information and the edge length of the sample chip layout.

12. The method according to any one of claims 1 to 11, wherein the determining a predicted mask layout of the sample chip layout through a neural network model comprises:

encoding the sample chip layout through the neural network model, to obtain a layout feature of the sample chip layout; and
decoding the layout feature of the sample chip layout through the neural network model, to obtain the predicted mask layout.

13. The method according to any one of claims 1 to 12, wherein the determining a first wafer layout of the predicted mask layout through a first wafer layout determining model comprises:

determining actual light intensity distribution information based on the predicted mask layout through the first wafer layout determining model, the actual light intensity distribution information being a light intensity distribution obtained after the predicted mask layout is imaged on a wafer under the conditions of the second lithography process parameter; and
determining the first wafer layout based on the actual light intensity distribution information through the first wafer layout determining model.

14. The method according to any one of claims 1 to 13, wherein the training the neural network model through the labeled mask layout, the predicted mask layout, the sample chip layout, and the first wafer layout, to obtain a model for determining a mask layout comprises:

determining a first target sub-loss through third difference information between the labeled mask layout and the predicted mask layout;
determining a second target sub-loss through fourth difference information between the sample chip layout and the first wafer layout;
determining a target loss based on the first target sub-loss and the second target sub-loss;
determining a second gradient of the target loss relative to a model parameter of the neural network model; and
adjusting the model parameter of the neural network model based on the second gradient, to obtain the model for determining a mask layout.

15. The method according to claim 14, the determining a target loss based on the first target sub-loss and the second target sub-loss comprises:

obtaining at least one of a third target sub-loss, a fourth target sub-loss, a fifth target sub-loss, a sixth target sub-loss, or a seventh target sub-loss, the third target sub-loss being determined based on the predicted mask layout, the fourth target sub-loss being determined based on fifth difference information between the sample chip layout and the predicted mask layout, the fifth target sub-loss being determined based on the fourth difference information and the edge modification information, the sixth target sub-loss being determined based on the predicted mask layout and the edge modification information, the seventh target sub-loss being determined based on the fifth difference information and the edge modification information, and the edge modification information being information for modifying the edge of the sample chip layout; and

determining the target loss based on the first target sub-loss, and the second target sub-loss, and at least one of the third target sub-loss, the fourth target sub-loss, the fifth target sub-loss, the sixth target sub-loss, or the seventh target sub-loss.

16. A method for determining a mask layout, executable by an electronic device, the method comprising:

obtaining a target chip layout; and

determining a target mask layout of the target chip layout through a model for determining a mask layout, the model for determining a mask layout being obtained by training through the method for training a model for determining a mask layout according to any one of claims 1 to 15, and the target mask layout being a mask layout of the target chip layout obtained by prediction.

17. The method according to claim 16, the determining a target mask layout of the target chip layout through a model for determining a mask layout comprises:

encoding the target chip layout through the model for determining a mask layout, to obtain a layout feature of the target chip layout; and

decoding the layout feature of the target chip layout through the model for determining a mask layout, to obtain the target mask layout.

18. A device for training a model for determining a mask layout, comprising:

an obtaining module configured to obtain a labeled mask layout and a sample chip layout, the labeled mask layout corresponding to the sample chip layout and being based on a first lithography process parameter;

a determining module configured to determine a predicted mask layout of the sample chip layout through a neural network model;

the determining module further configured to determine a first wafer layout of the predicted mask layout through a first wafer layout determining model, the first wafer layout determining model comprising a second lithography process parameter; and

a training module configured to train the neural network model through the labeled mask layout, the predicted mask layout, the sample chip layout, and the first wafer layout, to obtain a model for determining a mask layout.

19. A device for determining a mask layout, comprising:

an obtaining module configured to obtain a target chip layout; and

a determining module configured to determine a target mask layout of the target chip layout through a model for determining a mask layout, the model for determining a mask layout being obtained by training through the method for training a model for determining a mask layout according to any one of claims 1 to 15, and the target mask layout being a mask layout of the target chip layout obtained by prediction.

20. An electronic device, the electronic device comprising a processor and a memory, the memory having at least one computer program stored therein, and the at least one computer program being loaded and executed by the processor, to cause the electronic device to implement the model for determining a mask layout training method according to any one of claims 1 to 15 or the mask layout determining method according to any one of claims 16 to 17.

21. A non-volatile computer-readable storage medium, the non-volatile computer-readable storage medium having at least one computer program stored therein, and the at least one computer program being loaded and executed by a processor, to cause an electronic device to implement the method for training model for determining a mask layout according to any one of claims 1 to 15 or the mask layout determining method according to any one of claims 16 to 17.

22. A computer program product, the computer program product having at least one computer program stored therein, and the at least one computer program being loaded and executed by a processor, to cause an electronic device to implement the method for training model for determining a mask layout according to any one of claims 1 to 15 or the mask layout determining method according to any one of claims 16 to 17.

FIG. 1

| | |
|---|---|
| Obtain a labeled mask layout and a sample chip layout | 201 |
| Determine a predicted mask layout of the sample chip layout through a neural network model | 202 |
| Determine a first wafer layout of the predicted mask layout through a first wafer layout determining model | 203 |
| Train the neural network model through the labeled mask layout, the predicted mask layout, the sample chip layout, and the first wafer layout, to obtain a mask layout determining model | 204 |

FIG. 2

FIG. 3

Linearly modify a sample chip layout, to obtain an initial mask layout — 401

Input the initial mask layout to a second wafer layout determining model, to obtain a second wafer layout — 402

Determine a reference loss based on the sample chip layout, the initial mask layout, and the second wafer layout — 403

Determine a first gradient of the reference loss relative to the initial mask layout — 404

Adjust the initial mask layout based on the first gradient, to obtain an adjusted mask layout — 405

Determine whether an adjustment ending condition is satisfied — 406

No — Use the adjusted mask layout as the initial mask layout — 408

Yes

Determine, based on the adjusted mask layout, a labeled mask layout — 407

FIG. 4

Obtain a target chip layout — 501

Determine a target mask layout of the target chip layout through a mask layout determining model — 502

FIG. 5

Sample chip layout

Initial network model

Predicted mask layout

FIG. 6

Sample chip layout       Predicted mask layout       First wafer layout

Back propagation

FIG. 7

(a) Contact hole type       (b) Logic type

1: Mask layout obtained by optimization based on wafer layout determining model including reference lithography process parameter
2: Mask layout obtained by optimization based on wafer layout determining model including actual lithography process parameter
3: Mask layout determined based on neural network model obtained by pre-training
4: Mask layout determined based on mask layout determining model obtained by pre-training and optimal training

FIG. 8

FIG. 9

Mask layout determining apparatus

Obtaining module 1001

Determining module 1002

FIG. 10

1100

Processor 1101

Memory 1102

Display 1105

FIG. 11

Server 1200

Processor 1201

Memory 1202

FIG. 12

## INTERNATIONAL SEARCH REPORT

| | International application No. |
|---|---|
| | **PCT/CN2023/128438** |

### A. CLASSIFICATION OF SUBJECT MATTER

G06F30/398(2020.01)i

According to International Patent Classification (IPC) or to both national classification and IPC

### B. FIELDS SEARCHED

Minimum documentation searched (classification system followed by classification symbols)

IPC:G06F

Documentation searched other than minimum documentation to the extent that such documents are included in the fields searched

Electronic data base consulted during the international search (name of data base and, where practicable, search terms used)

CNABS; CNTXT; VEN; USTXT; WOTXT; EPTXT; CNKI; IEEE: 版图, 图案, 掩膜, 晶圆, 光刻, 模型, layout, pattern, mask, wafer, photoetching, model

### C. DOCUMENTS CONSIDERED TO BE RELEVANT

| Category* | Citation of document, with indication, where appropriate, of the relevant passages | Relevant to claim No. |
|---|---|---|
| PX | CN 116720479 A (TENCENT TECHNOLOGY (SHENZHEN) CO., LTD.) 08 September 2023 (2023-09-08) description, paragraphs 30-147 | 1-22 |
| X | CN 115222829 A (SHANDONG YUNHAI GUOCHUANG CLOUD COMPUTING EQUIPMENT INDUSTRY INNOVATION CENTER CO., LTD.) 21 October 2022 (2022-10-21) description, paragraphs 23-59 | 1-22 |
| X | CN 114326289 A (ADVANCED MANUFACTURING EDA CO., LTD.) 12 April 2022 (2022-04-12) description, paragraphs 28-88 | 1-22 |
| A | CN 113406858 A (NANJING JINGQU INTEGRATED CIRCUIT CO., LTD.) 17 September 2021 (2021-09-17) entire document | 1-22 |
| A | JP 2004157160 A (SONY CORP.) 03 June 2004 (2004-06-03) entire document | 1-22 |

☐ Further documents are listed in the continuation of Box C.      ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **17 January 2024** | **27 January 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
**Information on patent family members**

International application No.

**PCT/CN2023/128438**

| Patent document cited in search report | | | Publication date (day/month/year) | Patent family member(s) | | | Publication date (day/month/year) |
|---|---|---|---|---|---|---|---|
| CN | 116720479 | A | 08 September 2023 | CN | 116720479 | B | 09 January 2024 |
| CN | 115222829 | A | 21 October 2022 | None | | | |
| CN | 114326289 | A | 12 April 2022 | CN | 114326289 | B | 31 March 2023 |
| CN | 113406858 | A | 17 September 2021 | CN | 113406858 | B | 10 December 2021 |
| JP | 2004157160 | A | 03 June 2004 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310284682